# EUROPEAN PATENT APPLICATION

(11) **EP 4 706 972 A1**
(43) Date of publication of application: **11.03.2026**
(21) Application number: 25199215.2
(22) Date of filing: 29.08.2025
(51) Int. Cl.: B41J 3/407, G02F 1/13, H10K 71/13, H10K 71/70

(54) **APPARATUS AND METHOD FOR MANUFACTURING DISPLAY DEVICE**

(30) Priority: 05.09.2024 KR 20240120948
(71) Applicant: Samsung Display Co., Ltd., Yongin-si, Gyeonggi-do 17113 (KR)
(72) Inventor: LEE, Heejung, 17113 Yongin-si (KR); KIM, Jongsung, 17113 Yongin-si (KR); MIN, Honggi, 17113 Yongin-si (KR); LEE, Hansol, 17113 Yongin-si (KR); JEONG, Ilseok, 17113 Yongin-si (KR); CHOI, Byounghoon, 17113 Yongin-si (KR)
(74) Representative: Taor, Simon Edward William

(57) **Abstract**

Provided are an apparatus and a method for manufacturing a display device. The apparatus (1) includes an ink discharging unit (15) configured to move in a first direction and including a head unit (151) including a plurality of nozzles spaced apart from each other and configured to discharge ink on a substrate (DS) and a film member (133), wherein the ink is discharged through at least one nozzle unit including a plurality of columns, an inspection unit (13) including a film member including a same material as the substrate, a camera unit (16) configured to obtain first image information about the ink discharged on the film member, and a moving unit (17) configured to move the ink discharging unit and the camera unit in the first direction, wherein at least two nozzles to discharge ink are selected from among the plurality of nozzles based on the first image information.

## Description

### CROSS-REFERENCE TO RELATED APPLICATION

This application is based on and claims priority under 35 U.S.C. §119 to Korean Patent Application No. 10-2024-0120948, filed on September 5, 2024, in the Korean Intellectual Property Office.

### BACKGROUND

### 1. Field

One or more embodiments relate to an apparatus and a method, and more particularly, to an apparatus and a method for manufacturing a display device.

### 2. Description of the Related Art

Mobility-based electronic devices have been widely used. Recently, tablet personal computers (PCs), in addition to compact electronic devices, such as mobile phones, have become widely used as mobile electronic devices.

In order to support various functions, such mobile electronic devices include display devices for providing users with visual information, such as images and videos. As other components for driving display devices have recently been miniaturized, a proportion that display devices occupy in electronic devices has gradually increased, and a structure capable of being bent by a certain angle from a flat state has also been developed.

### SUMMARY

One or more embodiments include an apparatus for manufacturing a display device capable of discharging ink at an accurate position on a substrate.

However, this objective is only an example, and the objectives of the disclosure are not limited thereto.

Additional aspects will be set forth in part in the description which follows and, in part, will be apparent from the description, or may be learned by practice of the presented embodiments of the disclosure.

According to an aspect of the present disclosure, an apparatus for manufacturing a display device includes an ink discharging unit configured to move in a first direction and including a head unit including a plurality of nozzles spaced apart from each other and configured to discharge ink toward a substrate, an inspection unit including a film member including a same material as the substrate, a camera unit configured to obtain first image information about the ink discharged on the film member, a moving unit configured to move the ink discharging unit and the camera unit in the first direction, and a control unit configured to select at least two nozzles from among the plurality of nozzles to discharge the ink on the substrate based on the first image information.

In the present embodiment, the apparatus may further include a stage spaced apart from the head unit in a vertical direction and configured to move in a second direction crossing the first direction, wherein the substrate disposed on the stage and the vertical direction is perpendicular to a plane defined by the first direction and the second direction, wherein the control unit is configured further to control, based on second image information, the ink discharging unit to individually adjust a discharge timing at which each of the at least two nozzles discharges the ink, and wherein the camera unit is configured further to photograph the ink discharged on the substrate to obtain the second image information.

In the present embodiment, the control unit may be configured further to adjust the discharge timing of the ink discharging unit such that one of the at least two nozzles discharges the ink at a first discharge timing and another one of the at least two nozzles discharges the ink at a second discharge timing different from the first discharge timing.

In the present embodiment, the control unit may be configured further to obtain information of a total amount of the ink discharged on the substrate and a position where the ink is discharged on the substrate based on the second image information.

In the present embodiment, the control unit may be configured further to determine a moving speed of the ink discharging unit in the first direction and a position of the ink discharging unit based on the total amount of the ink discharged on the substrate and the position where the ink is discharged on the substrate.

In the present embodiment, the control unit may be configured further to control a movement of the stage so that the discharge timing of each of the at least two nozzles is adjusted by a moving distance of the stage.

In the present embodiment, the control unit may be configured further to generate, based on the first image information, first printing information including a discharge position at which the ink is to be discharged within the substrate.

In the present embodiment, the apparatus may further include a stage spaced apart from the head unit and configured to move in a second direction, wherein the substrate is disposed on the stage, wherein the camera unit obtains the second image information by photographing the ink discharged on the substrate, and wherein the control unit is configured further to calculate an injection error of each of the plurality of nozzles based on the first printing information and the second image information.

In the present embodiment, each of a surface of the film member and a surface of the substrate may be water-repellent.

In the present embodiment, the inspection unit may include an inspection stage configured to support the film member, and an inspection stage driving unit on which the inspection stage is mounted and configured to move the inspection stage linearly.

According to an aspect of the present disclosure, a method of manufacturing a display device includes disposing a film member on an inspection unit, discharging ink on the film member by a plurality of nozzles of an ink discharging unit, obtaining first image information by photographing the ink discharged on the film member, wherein the first image information includes a position of the ink discharged on the film member and a shape thereof, and selecting, based on the first image information, at least two nozzles, among the plurality of nozzles, to discharge the ink on a substrate.

In the present embodiment, the method may further include determining, based on the at least two nozzles, first printing information including a position at which the ink is to be discharged on the substrate.

In the present embodiment, the method may further include discharging, by the ink discharging unit based on the first printing information, the ink on the substrate disposed on a stage, obtaining, by a camera unit, second image information by photographing the ink discharged on the substrate, calculating an injection error of the ink discharging unit based on the first printing information and the second image information, wherein the first printing information includes a first coordinate of the position at which the ink is to be discharged on the substrate, wherein the second image information includes a second coordinate of a position of the ink in the second image information, and wherein the injection error corresponds to a difference between the second coordinate and the first coordinate, and generating second printing information based on the injection error, wherein the second printing information includes a position of the stage on which the substrate is placed, a position of the ink discharging unit, and a discharge timing when each of the plurality of nozzles discharges an ink at least one of which is different from a corresponding one of a previous second printing information.

In the present embodiment, the method may further include adjusting an operation of the ink discharging unit differently according to whether the injection error is positive or negative, wherein the injection error is positive when the second coordinate is greater than the first coordinate, and the injection error is negative when the second coordinate is smaller than the first coordinate.

In the present embodiment, an operation of each of the plurality of nozzles of the ink discharging unit may be individually adjusted based on the injection error.

In the present embodiment, the method may further include changing, based on the injection error, a timing at which the ink is discharged from at least one nozzle from among the plurality of nozzles.

In the present embodiment, the method may further include determining, based on the first image information, whether each of the plurality of nozzles normally operates.

In the present embodiment, a surface of the film member and a surface of the substrate are water-repellent.

In the present embodiment, the method may further includes setting a moving distance of a head unit of the ink discharging unit based on the injection error.

In the present embodiment, the method may further include moving the film member linearly.

According to an aspect, there is provided an apparatus for manufacturing a display device as set out in claim 1. Additional features of this aspect are set out in claims 1 to 8. According to an aspect, there is provided method as set out in claim 9. Additional features of this aspect are set out in claims 10 to15.

Other aspects, features and advantages other than those described above will become apparent from the following drawings, claims and detailed description of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view of an apparatus for manufacturing a display device, according to an embodiment of the present disclosure;
FIG. 2 is a plan view of an ink discharging unit according to an embodiment of the present disclosure;
FIG. 3 is a bottom view illustrating a portion of a head unit of an ink discharging unit according to an embodiment of the present disclosure;
FIG. 4 is a perspective view illustrating a film member, an inspection stage and a camera unit according to an embodiment of the present disclosure;
FIG. 5 is a plan view illustrating a relationship between ink discharged by an apparatus for manufacturing a display device and a set position, according to an embodiment of the present disclosure;
FIG. 6 is a perspective view illustrating a display device according to an embodiment of the present disclosure;
FIG. 7 is a cross-sectional view illustrating a display device according to an embodiment of the present disclosure;
FIGS. 8 and 9 are cross-sectional views illustrating a display device according to an embodiment of the present disclosure;
FIG. 10 is a plan view illustrating a portion of a color conversion panel according to an embodiment of the present disclosure;
FIG. 11 is a perspective view illustrating a display device according to an embodiment of the present disclosure;
FIG. 12 is an exploded perspective view illustrating the display device shown in FIG. 11 according to an embodiment of the present disclosure; and
FIG. 13 is a block diagram illustrating the display device shown in FIG. 6 or 11 according to an embodiment of the present disclosure.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, certain embodiments will be illustrated in the drawings and described in detail in the written description. Hereinafter, effects and features of the disclosure and a method for accomplishing them will be described more fully with reference to the accompanying drawings, in which embodiments of the disclosure are shown. The disclosure may, however, be embodied in many different forms and should not be construed as limited to the embodiments set forth herein.

Hereinafter, embodiments will be described with reference to the accompanying drawings, wherein like reference numerals refer to like elements throughout and a repeated description thereof is omitted.

In an embodiment below, terms such as "first" and "second" are used herein merely to describe a variety of elements, but the elements are not limited by the terms. Such terms are used only for the purpose of distinguishing one element from another element.

In an embodiment below, an expression used in the singular encompasses the expression of the plural, unless it has a clearly different meaning in the context.

In an embodiment below, terms such as "include" or "comprise" may be construed to denote a certain characteristic, element, or a combination thereof, but may not be construed to exclude the existence of or a possibility of addition of one or more other characteristics, elements, or combinations thereof.

It will be understood that when a layer, region, or element is referred to as being "formed on" another layer, region, or element, it can be directly or indirectly formed on the other layer, region, or element. That is, for example, intervening layers, regions, or elements may be present.

Sizes of elements in the drawings may be exaggerated or reduced for convenience of explanation. For example, since sizes and thicknesses of elements in the drawings are arbitrarily illustrated for convenience of explanation, embodiments of the disclosure are not limited thereto.

In the following embodiments, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When an embodiment may be implemented differently, a certain process order may be performed differently from the described order. For example, two consecutively described processes may be performed substantially at the same time or performed in an order opposite to the described order. In the display field, inkjet printing devices may perform control at the head level for error correction. However, this approach does not address errors that occur at individual nozzles within each head, making it impossible to achieve precise pattern printing. To overcome this limitation, the method described in this disclosure calculates errors for each nozzle, enabling precise control of the ink discharge timing for every nozzle.

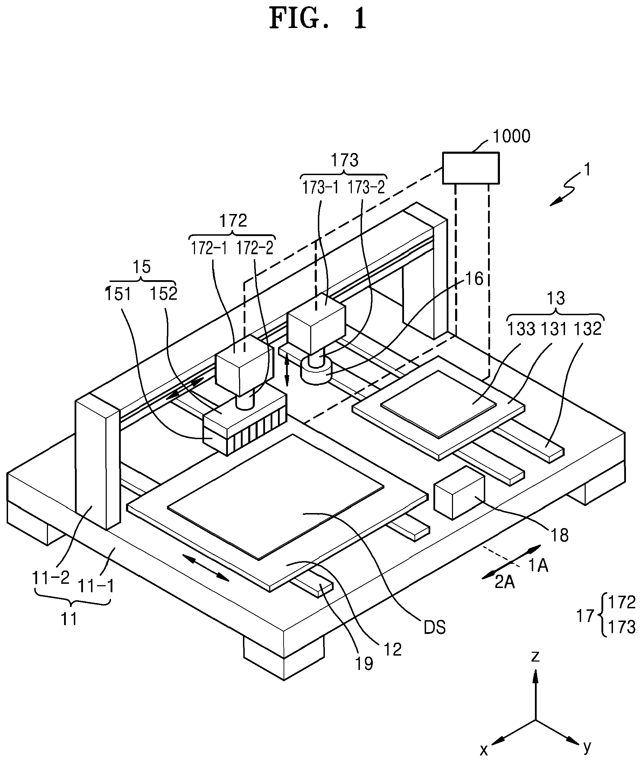

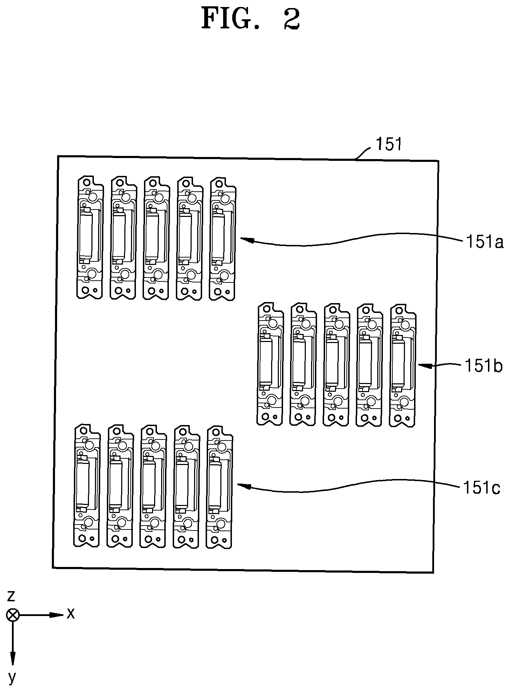

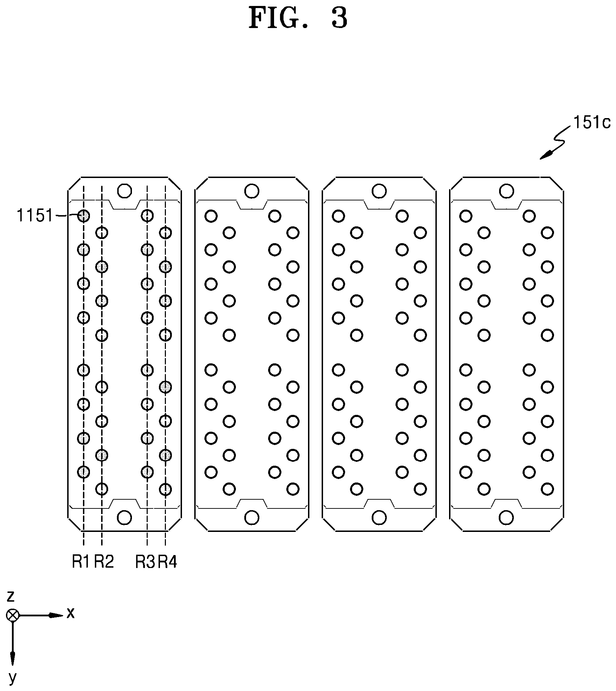

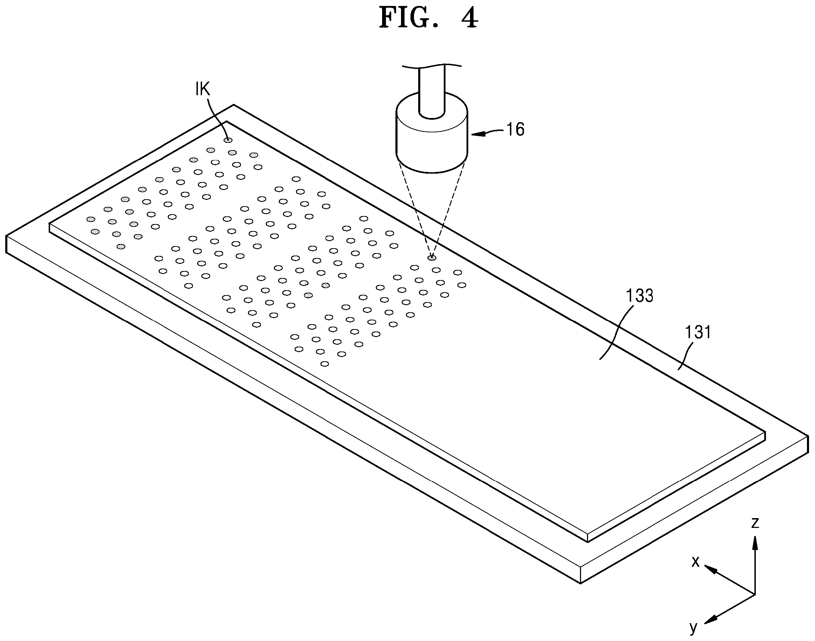

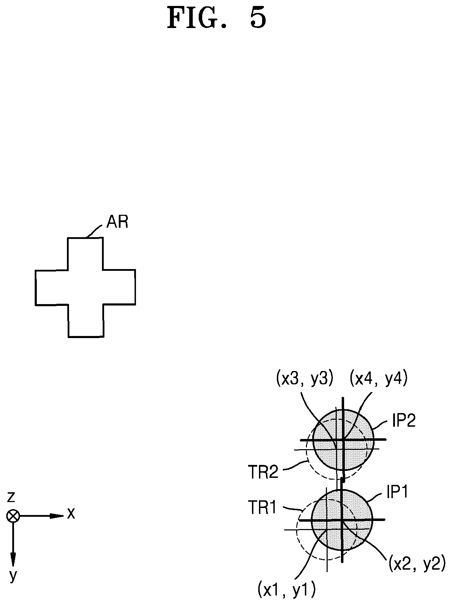

FIG. 1 is a perspective view of an apparatus 1 for manufacturing a display device, according to an embodiment. FIG. 2 is a plan view of an ink discharging unit 15 of the apparatus 1 according to an embodiment. FIG. 3 is a bottom view illustrating a portion of a head unit 151 of the ink discharging unit 15 according to an embodiment. FIG. 4 is a perspective view illustrating a film member 133, an inspection stage 131 and a camera unit 16 of the apparatus 1 according to an embodiment. FIG. 5 is a plan view illustrating a relationship between ink discharged by the apparatus 1 for manufacturing a display device and a set position, according to an embodiment.

Referring to FIGS. 1 to 5, the apparatus 1 for manufacturing a display device may be divided into a first area 1A and a second area 2A. In an embodiment, the first area 1A may be an area in which an inspection is performed, and the second area 2A may be an area in which an actual process in which an ink is discharged toward a display substrate is performed.

The apparatus 1 for manufacturing a display device may include a support unit 11, a stage 12, an inspection unit 13, the ink discharging unit 15, the camera unit 16, a moving unit 17, a cleaning unit 18, a stage driving unit 19, and a control unit 1000.

The support unit 11 may support the stage 12, the inspection unit 13, the ink discharging unit 15, the camera unit 16, the moving unit 17, and the cleaning unit 18. The support unit 11 may include a first support unit 11-1 and a second support unit 11-2. The first support unit 11-1 may be in a plane defined by a first direction (e.g., x-axis direction) and a second direction (e.g., y-axis direction) crossing the first direction (e.g., x-axis direction). The second support unit 11-2 may be disposed on the first support unit 11-1. A portion of the second support unit 11-2 may be spaced apart from the first support unit 11-1 in a third direction (e.g., z-axis direction) to support the head unit 151 and the camera unit 16. For example, the second support unit 11-2 may be erected from an upper surface of the first support unit 11-1 in the third direction.

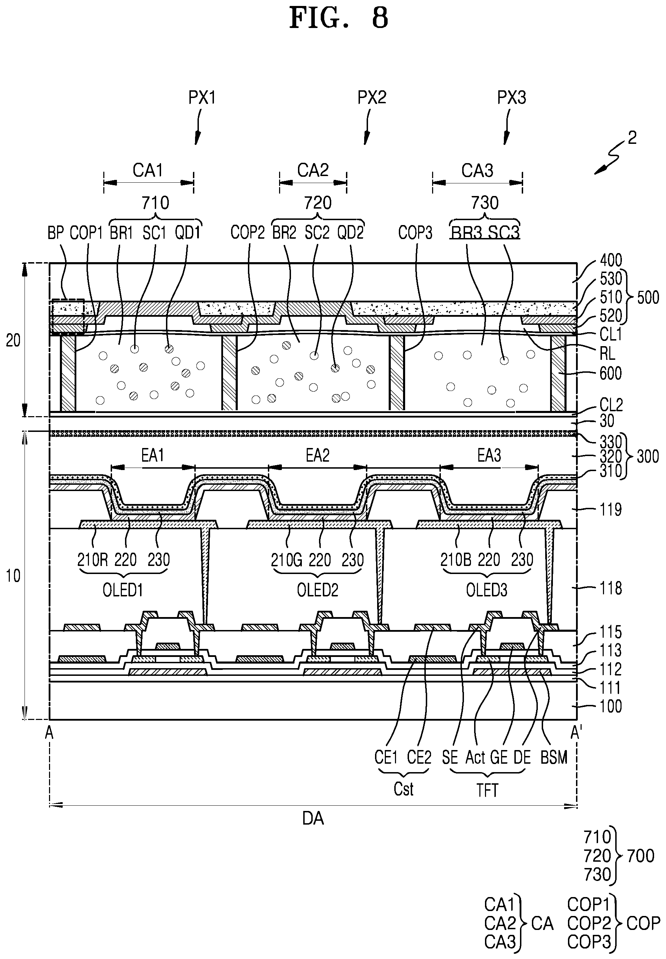

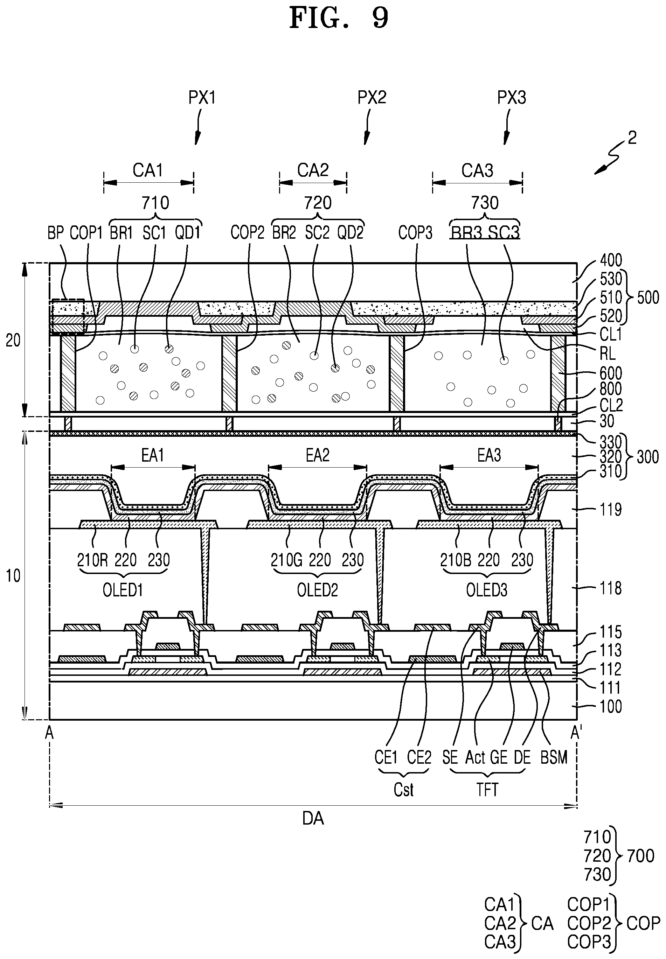

The stage 12 may be disposed on the first support unit 11-1, and may have a plane defined by the first direction and the second direction. A display substrate DS may be mounted on the stage 12, and the stage 12 may include an alignment mark (not shown) for aligning the display substrate DS. The display substrate DS is a part of a display device to be manufactured and may be a target on which the ink discharging unit 15 discharges ink IK(see FIG.4). For example, the discharged ink IK may be disposed on the display substrate DS and may constitute a partial layer of the display device. The stage 12 may constitute a working area of an inkjet printing process. The display substrate DS described above may include a lower substrate 100 shown in FIGS. 8 and 9 and some layers (e.g., layers up to a pixel-defining layer 119 of shown in FIGS. 8 and 9) disposed on the lower substrate 100, or the display substrate DS may include an upper substrate 400, a color filter layer 500, a refractive layer RL, and a bank 600. In another embodiment, the display substrate DS may include the lower substrate 100 shown in FIGS. 8 and 9 and all layers disposed on the lower substrate 100 up to a first inorganic encapsulation layer 310. Hereinbelow, for convenience of description, it is described in detail a case where the display substrate DS includes the upper substrate 400, the color filter layer 500, the refractive layer RL, and the bank 600.

The inspection unit 13 may be disposed on the first support unit 11-1. Before the ink discharging unit 15 discharges the ink IK on the display substrate DS, the inspection unit 13 may be a target to which the ink IK is discharged. A film member 133 in the inspection unit 13 may include a material identical to a material of the display substrate DS disposed on the stage 12.

The inspection unit 13 may include an inspection stage 131, the inspection stage driving unit 132, and the film member 133.

The inspection stage 131 may be disposed to move linearly on the first support unit 11-1 and may constitute the exterior of the inspection unit 13. The inspection stage 131 may support the film member 133.

The inspection stage driving unit 132 may be disposed between the first support unit 11-1 and the inspection stage 131 and may linearly move the inspection stage 131. The inspection stage driving unit 132 may have various shapes. For example, the inspection stage driving unit 132 may include a linear motor between the first support unit 11-1 and the inspection stage 131, and the linear motor may connect the first support unit 11-1 and the inspection stage 131 to each other. In another embodiment, the inspection stage driving unit 132 may include a ball screw disposed between the first support unit 11-1 and the inspection stage 131 and connected to the inspection stage 131, and a motor disposed on the first support unit 11-1 and connected to the ball screw to rotate the ball screw. In another embodiment, the inspection stage driving unit 132 may include a cylinder disposed on the first support unit 11-1 and connected to the inspection stage 131. In this case, the inspection stage driving unit 132 is not limited thereto, and may include any structure and device that linearly moves the inspection stage 131.

The film member 133 may include a material identical to a material of the display substrate DS. For example, one surface of the film member 133 may be coated with a material identical to a material of the display substrate DS. For example, a surface of the film member 133 and a surface of the display substrate DS may be water-repellent. The film member 133 may be disposed to face the ink discharging unit 15 and the camera unit 16. The ink discharging unit 15 may discharge the ink IK. In this case, the ink IK may be a polymer or low-molecular weight organic material corresponding to an emission layer of an organic light-emitting display device. In another embodiment, the ink IK may be a red, green, or blue liquid containing pigment particles mixed in a liquid crystal, an alignment agent, or a solvent. In another embodiment, the ink IK may include a solution including inorganic particles, such as quantum dot materials. Hereinbelow, for convenience of description, it is mainly described in detail a case where the ink IK is a solution including inorganic particles, such as quantum dot materials.

The ink discharging unit 15 may include the head unit 151 and a connection unit 152. The head unit 151 may spray the ink IK toward the display substrate DS and the inspection unit 13. The head unit 151 may be provided in plurality. For example, the plurality of head units 151 may linearly disposed in the first direction (e.g., x-axis direction). The connection unit 152 may connect the plurality of head units 151 to each other. The connection unit 152 may be fixed to the moving unit 17.

Each of the head units 151 may include a plurality of nozzle units 151a, 151b, and 151c. The plurality of nozzle units 151a, 151b, and 151c may include a first nozzle unit 151a, a second nozzle unit 151b, and a third nozzle unit 151c, which are spaced apart from each other. In this case, the first nozzle unit 151a, the second nozzle unit 151b, and the third nozzle unit 151c may discharge the ink IK containing different materials from each other. Hereinbelow, for convenience of description, the third nozzle unit 151c is mainly described in detail.

The third nozzle unit 151c may include a plurality of third nozzles in a row. In this case, each of the third nozzle units 151c may include a plurality of nozzles 1151. The plurality of nozzles 1151 may be arranged in a plurality of rows. For example, the plurality of nozzles 1151 may be arranged in four rows. For example, the plurality of nozzles 1151 may be disposed in a first row R1, a second row R2, a third row R3, and a fourth row R4. In this case, eight nozzles 1151 may be disposed in each of the first row R1, the second row R2, the third row R3, and the fourth row R4. In this case, in each row, the plurality of nozzles 1151 may be spaced apart from each other. In addition, the plurality of nozzles 1151 disposed in one of the first row R1, the second row R2, the third row R3, and the fourth row R4 may be staggered from the plurality of nozzles 1151 disposed in another one of the first row R1, the second row R2, the third row R3, and the fourth row R4. For example, the plurality of nozzles 1151 disposed in one of the first row R1, the second row R2, the third row R3, and the fourth row R4 and the plurality of nozzles 1151 disposed in another one of the first row R1, the second row R2, the third row R3, and the fourth row R4 may be arranged in a serpentine or zigzag manner with respect to each other.

The ink IK may be discharged through the plurality of nozzles 1151. In this case, the first nozzle unit 151a may discharge the ink IK including a first material, the second nozzle unit 151b may discharge the ink IK including a second material, and the third nozzle unit 151c may discharge the ink IK including a third material. Hereinbelow, for convenience of description, the third nozzle unit 151c discharging the ink IK including the third material is described in detail.

The plurality of nozzles 1151 may be arranged along one surface of the ink discharging unit 15, e.g., a lower surface of the third nozzle unit 151c, so as to be directed toward the display substrate DS and the inspection unit 13. The plurality of head units 151 may receive the ink IK through the connection unit 152. In FIG. 3, it is shown that the third nozzle unit 151c of each of the head units 151 is provided with 16 rows and four columns of nozzles 1151. However, this is only an example, and the arrangement and number of the head unit 151 are not limited thereto.

The camera unit 16 is disposed to face the inspection unit 13 and may photograph the ink IK discharged on the inspection unit 13. The camera unit 16 may obtain image information of the discharged ink IK. Although not shown in the drawings, the camera unit 16 may include a plurality of camera units 16. In this case, one of the plurality of camera units 16 may be disposed in the first area 1A, and another one of the plurality of camera units 16 may be disposed in the second area 2A.

The moving unit 17 may move the ink discharging unit 15 and the camera unit 16. For example, the moving unit 17 may move the ink discharging unit 15 and the camera unit 16 in the first direction (e.g., x-axis direction), the second direction (e.g., the y-axis direction), and the third direction (e.g., z-axis direction). The ink discharging unit 15 and the camera unit 16 may move freely on the first support unit 11-1. The moving unit 17 may include a first moving unit 172 and a second moving unit 173.

The first moving unit 172 may move the ink discharging unit 15 in the first direction (e.g., x-axis direction), the second direction (e.g., the y-axis direction), and the third direction (e.g., z-axis direction). The first moving unit 172 may include a first-1 moving unit 172-1 and a first-2 moving unit 172-2. The first-1 moving unit 172-1 may be disposed to be connected to the second support unit 11-2, and may move in the first direction (e.g., x-axis direction) and the second direction (e.g., the y-axis direction) with respect to the second support unit 11-2. The first-2 moving unit 172-2 may be disposed to be connected to the first-1 moving unit 172-1, and may linearly move in the third direction (e.g., z-axis direction) with respect to the first-1 moving unit 172-1. The ink discharging unit 15 may be fixed to the first-2 moving unit 172-2. With the first-1 moving unit 172-1 and the first-2 moving unit 172-2, the ink discharging unit 15 may move in the first direction (e.g., x-axis direction), the second direction (e.g., y-axis direction), and the third direction (e.g., z-axis direction).

The second moving unit 173 may move the camera unit 16 in the first direction (e.g., x-axis direction), the second direction (e.g., the y-axis direction), and the third direction (e.g., z-axis direction). The second moving unit 173 may include a second-1 moving unit 173-1 and a second-2 moving unit 173-2. The second-1 moving unit 173-1 may be disposed to be connected to the second support unit 11-2, and may move in the first direction (e.g., x-axis direction) and the second direction (e.g., the y-axis direction) with respect to the second support unit 11-2. The second-2 moving unit 173-2 may be disposed to be connected to the second-1 moving unit 173-1, and may linearly move in the third direction (e.g., z-axis direction) with respect to the second-1 moving unit 173-1. The camera unit 16 may be fixed to the second-2 moving unit 173-2. With the second-1 moving unit 173-1 and the second-2 moving unit 173-2, the camera unit 16 may move in the first direction (e.g., x-axis direction), the second direction (e.g., y-axis direction), and the third direction (e.g., z-axis direction).

The cleaning unit 18 may be disposed on the first support unit 11-1, and may be spaced apart from the stage 12. The ink discharging unit 15 may move in the first direction (e.g., x-axis direction) and the second direction (e.g., y-axis direction) to overlap the cleaning unit 18. In other words, the cleaning unit 18 may be at a position where the cleaning unit 18 may overlap the ink discharging unit 15.

When the ink IK is dried or viscosity of the ink IK increases within the nozzle 1151 of the ink discharging unit 15, a problem such as clogging of the nozzle 1151 may occur. When the ink IK remaining in the nozzle 1151 contains foreign substances or air bubbles the ink discharging unit 15 may cause a high possibility of ink discharge failure. This may adversely affect the manufacturing quality, productivity, and yield of the display device.

The ink discharging unit 15 may regularly discharge the ink IK through the nozzle 1151 in an area other than the working area. For example, the moving unit 17 may transport the ink discharging unit 15 from above the stage 12 to above the cleaning unit 18, so that the ink discharging unit 15 may be disposed to overlap the cleaning unit 18 above the cleaning unit 18 and then discharge the ink IK. The ink IK discharged from the ink discharging unit 15 may be sucked and removed by the cleaning unit 18. With the cleaning unit 18, problems such as clogging of the nozzle 1151 of the ink discharging unit 15 and occurrence of poor discharge of the ink IK may be prevented in advance.

In order for the cleaning unit 18 to suck and remove the ink IK discharged from the ink discharging unit 15, a plurality of holes may be defined in the upper surface of the cleaning unit 18. In a state where the ink discharging unit 15 and the cleaning unit 18 overlap each other, for example, a lower surface of the ink discharging unit 15 and an upper surface of the cleaning unit 18 may face each other, the discharged ink IK may be sucked into the cleaning unit 18 through the plurality of holes. For example, the plurality of holes of the cleaning unit 18 may be aligned with the plurality of nozzles 1151 for cleaning the plurality of nozzles 1151.

The stage driving unit 19 may be disposed between the stage 12 and the first support unit 11-1 to allow the stage 12 to linearly reciprocate in the second direction (e.g., y-axis direction). In this case, the stage driving unit 19 may move the stage 12 at a constant interval and/or at a constant speed. Because the stage driving unit 19 is identical or similar to the inspection stage driving unit 132 described above, detailed descriptions thereof are omitted.

The control unit 1000 may control the inspection unit 13, the ink discharging unit 15, the camera unit 16, the moving unit 17, the cleaning unit 18, and the stage driving unit 19. The control unit 1000 is described in detail below.

The ink discharging unit 15 may discharge the ink IK on the film member 133 supported by the inspection stage 131. For example, an arrangement of the ink IK discharged on the film member 133 may correspond to an arrangement of the plurality of nozzles 1151. When the ink IK is discharged on the film member 133 of the inspection unit 13, the camera unit 16 may photograph the ink IK discharged on the film member 133. The camera unit 16 may include a line scan camera. The line scan camera may be an imaging device that captures images one line at a time, rather than as a full frame.

Regarding the operation of the apparatus 1 for manufacturing a display device described above, first, the head unit 151 may be disposed on the film member 133. Then, each third nozzle unit 151c may dispose the ink IK on the film member 133. In this case, the inspection stage driving unit 132 may move the inspection stage 131 in the second direction (e.g., y-axis direction).

When the above process is completed, the camera unit 16 may generate first image information by photographing the ink IK on the film member 133. The camera unit 16 may detect the ink IK on the film member 133 along a column or detect a plurality of droplets of ink IK disposed in one column at once. Hereinbelow, for convenience of description, it is mainly described in detail a case where the plurality of droplets of ink IK disposed in one column are all detected at once.

The camera unit 16 may photograph the first image information and transmit the photographed first image information to the control unit 1000, and the control unit 1000 may analyze the first image information and identify error information of the nozzle 1151. The first image information may be a position and shape of the ink IK on a plane where the ink IK shown in FIG. 4 is disposed on the film member 133. The control unit 1000 may identify whether the nozzle 1151 normally operates, through the error information of the nozzle 1151. Through such error information of the nozzle 1151, it may be analyzed whether the position of the ink IK corresponds to a preset position, whether a volume of the ink IK corresponds to a preset volume, whether the ink IK exists, or whether additional ink IK exists adjacent to the ink IK disposed within a certain range of a reference point. The control unit 1000 may select at least two nozzles 1151 to be used among the plurality of nozzles 1151 based on the analysis results of the first image information as described above. For each column, the control unit 1000 may select at least one nozzle 1151 to be used. For example, the first image information may be analyzed, and except for a nozzle 1151 that cannot be used, such as when the ink IK is not discharged from the nozzle 1151 among the plurality of nozzles 1151 disposed in one column or an amount of the discharged ink IK is small, and when the position of the discharged ink IK is not positioned within a preset range, if a nozzle 1151 adjacent to such nozzle 1151 is normal, this nozzle 1151 may be selected. In this case, the control unit 1000 may select at least one of the plurality of nozzles 1151 for discharging the ink IK on one discharge area (not shown).

The control unit 1000 may calculate a first impact position IP1 at which the ink IK actually impacts based on a reference position (or reference point, e.g., alignment mark AR) for each ink IK in the first image information. For example, the control unit 1000 may obtain the first impact position IP1, relative to the reference position of the alignment mark AR, of the ink IK on the first image information. The control unit 1000 may calculate a first injection error (x2-x1, y2-y1), which is a difference between a preset first set position TR1 and the first impact position IP1 where the ink IK actually impacts, for each ink IK. The control unit 1000 may store the first set position TR1 relative to the reference position and calculate the first impact position IP1 in the form of coordinates relative to the reference position. The first set position TR1 may be a preset position at which the ink IK discharged from the nozzle 1151 is to impact on the film member 133 based on the position of the corresponding inspection stage 131, the position of the head unit 151, and the position of the corresponding nozzle 1151 within the head unit 151. The first injection error (x2-x1, y2-y1) (i.e., a test injection error) may include a first test error component of (x2-x1) in the first direction (e.g., x-axis direction) and a second test error component of (y2-y1) in the second direction (e.g., y-axis direction).

The control unit 1000 may select at least one nozzle 1151 to be used, which has the smallest difference between the first set position TR1 and the first impact position IP1. For example, the control unit 1000 may select a nozzle 1151 with the smallest first injection error (x2-x1, y2-y1) as the nozzle 1151 to be used. For example, the control unit 1000 may select a nozzle 1151 to be used that has the smallest straight-line distance between the first set position TR1 and the first impact position IP1. In another embodiment, the control unit 1000 may select a nozzle 1151 to be used that has the smallest one of the first test error component of (x2-x1) and/or the second test error component of (y2-y1). In an embodiment, at least two of the plurality of nozzles 1151 may be used in one area (e.g., a planar area of one code element). For example, the control unit 1000 may sequentially select a nozzle 1151 among the plurality of nozzles 1151 that supply the ink IK to one area to be used, starting with the nozzle 1151 with the smallest difference between the first set position TR1 and the first impact position IP1. In an embodiment, the control unit 1000 may perform the above process in each of the plurality of nozzles 1151 disposed in each column.

When the above process is completed, the control unit 1000 may generate first printing information by determining a movement of the head unit 151 and a movement of the stage 12 to provide the ink IK to each sub-pixel (e.g., discharge area) in an inkjet manner through the plurality of nozzles 1151 selected based on a size of a substrate, a distance between the substrate and a sub-pixel, and the first injection error (x2-x1, y2-y1). The first printing information, as well as the second printing information, the third printing information, and the fourth printing information described below, may include the position of the stage 12 on which the display substrate DS is placed, the position of the ink discharging unit 15, and the discharge timing when each of the plurality of nozzles 1151 discharges an ink IK.

The control unit 1000 may control the first moving unit 172 to dispose the head unit 151 to face the stage 12. The camera unit 16 may photograph an alignment mark (not shown) on the display substrate DS, and the head unit 151 may be disposed so that the alignment mark and the head unit 151 correspond to the initialization position.

The control unit 1000 may initially discharge the ink IK on the display substrate DS on the stage 12 based on the first printing information. The control unit 1000 may keep the stage 12 in a stopped state.

The camera unit 16 may photograph the ink IK disposed on the display substrate DS. In an embodiment, a method of photographing the ink IK by the camera unit 16 is identical or similar to that described above, and redundant descriptions thereof are omitted.

Second image information photographed by the camera unit 16 may be transmitted to the control unit 1000. Although not shown in the drawings, the second image information may include a planar position and shape of the ink IK disposed on the display substrate DS. The second image information may be similar to the first image information. From the second image information, the control unit 1000 may identify whether the ink IK is disposed at a preset position. For example, the control unit 1000 may calculate a second impact position IP2, which is an actual position where the ink IK is actually disposed on the display substrate DS, based on the reference position (or reference point, e.g., the alignment mark AR). The control unit 1000 may calculate a second injection error (x4-x3, y4-y3) based on the first printing information and the second image information. For example, the control unit 1000 may compare a second set position TR2, based on the first printing information, where the ink IK is to be disposed and the second impact position IP2 obtained from the second image information, and calculate the second injection error (x4-x3, y4-y3), which is a degree to which the second set position TR2 and the second impact position IP2 are different from each other. The second set position TR2 and the second impact position IP2 may be in the form of coordinates based on the reference position, similar to the first set position TR1 and the first impact position IP1. For example, the second set position TR2 may be obtained from the first printing information, and the second impact position IP2 may be obtained from the second image information. For example, the second set position TR2 (x3, y3) relative to the reference point of the alignment mark AR may be obtained from the first printing information, and the second impact position IP2 may be (x4, y4) which is relative to the reference point of the alignment mark AR and which may be obtained from the second image information. The second injection error (x4-x3, y4-y3) described above may include a first injection error component of (x4-x3), which is a difference between the second set position TR2 and the second impact position IP2 in the first direction (e.g., x-axis direction), and a second injection error component (y4-y3), which is a difference between the second set position TR2 and the second impact position IP2 in the second direction (e.g., y-axis direction). The control unit 1000 may calculate a total volume of the ink IK disposed in one impact area based on the second image information.

The control unit 1000 may determine whether the first injection error component of (x4-x3) is within a certain range. When the control unit 1000 determines that the first injection error component of (x4-x3) is within the certain range, the control unit 1000 may use the nozzle 1151 that previously discharged the ink IK, based on the first printing information. The nozzle 1151 which previously discharged the ink IK with the first injection error component of (x4-x3) within the certain range may be referred to as the existing nozzle 1151.

When using the existing nozzle 1151, the control unit 1000 may generate second printing information obtained by applying the second injection error (x4-x3, y4-y3) to the first printing information and changing a discharge timing of the nozzle 1151. For example, the control unit 1000 may generate the second printing information for changing the position of the head unit 151 that starts discharging the ink IK from the nozzle 1151 and the moving distance and moving speed of the head unit 151 in the first direction (e.g., x-axis direction) to be differently from before based on the first injection error component of (x4-x3), which is an error in the first direction (e.g., x-axis direction) and a volume of the impact disposed in one impact area. For example, the control unit 1000 may set the position and moving distance of the head unit 151 that starts discharging the ink IK, to be differently from before, based on the first injection error component of (x4-x3). For example, when the first injection error component of (x4-x3) has a positive value, the second impact position IP2 may not be disposed at the second set position TR2, but may be disposed past the second set position TR2 in the moving direction of the head unit 151. The control unit 1000 may generate the second printing information in which the position of the head unit 151 that starts discharging the ink IK is pushed backward with respect to the moving direction of the head unit 151 compared to the existing set position. When the first injection error component of (x4-x3) has a negative value, the second impact position IP2 may be disposed in the first direction, before passing through the second set position TR2 in the moving direction of the head unit 151 compared to the second set position TR2. The control unit 1000 may generate the second printing information in which the position of the head unit 151 that starts discharging the ink IK is moved forward with respect to the moving direction of the head unit 151 compared to the existing set position.

The control unit 1000 may change and store a discharging timing of the nozzle 1151 set in the first printing information based on the second injection error component of (y4-y3), which is an error in the second direction (e.g., y-axis direction). For example, when the second injection error component of (y4-y3) has a positive value, the control unit 1000 may determine that the second impact position IP2 is disposed later than (i.e., disposed at a position past) the second set position TR2 with respect to the moving direction (e.g., y-axis direction) of the stage 12. The control unit 1000 may generate the second printing information in which the position of the stage 12 on which the display substrate DS is placed is changed to a new position so that the second impact position IP2 corresponds to the second set position TR2. The new position of the ink IK is obtained by adding a certain distance to the preset position of the stage 12 in the moving direction of the stage 12.

When the second injection error component of (y4-y3) has a negative value, the control unit 1000 may determine that the second impact position IP2 is disposed earlier than (i.e., at a position before) the second set position TR2 with respect to the moving direction (e.g., y-axis direction) of the stage 12. The control unit 1000 may generate the second printing information in which the position of the stage 12 that discharges the ink IK is changed to a new position of the stage 12 so that the second impact position IP2 corresponds to the second set position TR2. The new position of the ink IK is obtained by subtracting a certain distance from the preset position of the stage 12 in the moving direction of the stage 12.

The control unit 1000 may determine a common position of the stage 12 at which the plurality of nozzles 1151 must discharge the ink IK according to the second printing information. The common position of the stage 12 may be determined through a minimum moving distance of the stage 12 or a moving speed of the stage 12. The control unit 1000 may compare the common position of the stage 12 and the second impact position IP2 to each other. In order to resolve a difference between the common position of the stage 12 and the second impact position IP2, the control unit 1000 may adjust a timing at which each nozzle 1151 discharges. For example, at least one of the plurality of nozzles 1151 may discharge the ink IK after a certain time has elapsed or before a certain time has elapsed from the common position of the stage 12 rather than discharging the ink IK at the common position of the stage 12. In this case, the control unit 1000 may individually perform the operation described above, for each nozzle 1151. For example, at least one of the plurality of nozzles 1151 may become different in discharge timing from another one of the plurality of nozzles 1151. The control unit 1000 may control changing of the discharge timing of the nozzle 1151 through a current applied to the nozzle 1151. In an embodiment, each nozzle 1151 includes a piezoelectric element, and a timing of discharging the ink IK may vary depending on the applied current. For example, a time point when the current is applied to the piezoelectric element may determine the discharge timing of the nozzle 1151. With the adjustment of the discharge timing, the ink IK may be discharged at an accurate position.

When it is determined that the first injection error component of (x4-x3) is outside the certain range, the control unit 1000 may change the existing nozzle 1151 to a new nozzle 1151. A method in which the control unit 1000 changes the existing nozzle 1151 to the new nozzle 1151 may start with selection of the nozzle 1151 with the smallest first injection error as described above. The first injection error is calculated through the first image information. The control unit 1000 may select, as the new nozzle 1151, at least one of the plurality of nozzles 1151 that overlaps one discharge area overlapping the existing nozzle 1151. When the new nozzle 1151 is selected, the control unit 1000 may change the first printing information to third printing information corresponding to the new nozzle 1151. The control unit 1000 may store a plurality of pieces of printing information, which is a printing method, according to selection of the nozzle 1151. The control unit 1000 may select one of the plurality of pieces of information according to selection of the new nozzle 1151.

The control unit 1000 may move the head unit 151 or the stage 12 by a certain distance from the initial position based on the third printing information, and then calculate the second injection error (x4-x3, y4-y3) again, as described above. The control unit 1000 may perform an operation similar to the method of retaining the first printing information as is, the method of changing the first printing information to the second printing information, or the operation of changing the first printing information to the third printing information.

When the above process is completed, the control unit 1000 may control the stage driving unit 19 and the head unit 151 to discharge the ink IK on the display substrate DS on the stage 12, while moving the stage 12 in the second direction (e.g., y-axis direction) based on the first printing information, the second printing information, or the third printing information. The stage driving unit 19 may detect the position of the stage 12 according to an operation position, and transmit the detected position of the stage 12 to the control unit 1000. The control unit 1000 may compare the transmitted position of the stage 12 and the position of the stage 12 to which the ink IK is to be discharged from each nozzle 1151, stored in the first printing information, and control the head unit 151 to discharge the ink IK from the nozzle 1151.

The control unit 1000 may change the first printing information to the second printing information and control the first moving unit 172 to move the head unit 151 from the first area 1A to the second area 2A. Thereafter, as described above, the ink IK may be discharged on the display substrate DS, and then the above operation may be performed again.

When the above process is completed, the control unit 1000 may control the first moving unit 172 to move the head unit 151 from the second area 2A to the first area 1A. Thereafter, the control unit 1000 may discharge the ink IK on the film member 133 and then, obtain the first image information. The control unit 1000 may determine whether to use the previously-used nozzle 1151 based on the first image information obtained again. In this case, the determination of whether to use the nozzle 1151 is identical or similar to selecting the nozzle 1151 to be used, described above, and thus detailed descriptions thereof are omitted.

When replacing the existing nozzle 1151 with the new nozzle 1151 through the first image information, the control unit 1000 may change the first printing information, the second printing information, or the third printing information to fourth printing information through the first injection error (x2-x1, y2-y1). In this case, when the existing nozzle 1151 from among the plurality of nozzles 1151 is used, the control unit 1000 may change the first printing information to the second printing information only for the corresponding nozzle 1151, and when a new nozzle 1151 from among the plurality of nozzles 1151 is used, the control unit 1000 may change the first printing information to the fourth printing information only for the corresponding nozzle 1151, as described above.

Thereafter, the head unit 151 may discharge the ink IK on the display substrate DS, the camera unit 16 may obtain the second image information, and the control unit 1000 may determine whether to retain the fourth printing information based on the second image information, or to perform an operation such as changing the first printing information to the second printing information or changing the first printing information to the third printing information.

The operation described above may be repeatedly performed.

Therefore, in the apparatus 1 for manufacturing a display device and a method of manufacturing a display device, the ink IK may be discharged in a precise pattern by individually controlling the nozzles 1151 disposed in each column. In addition, in the apparatus 1 for manufacturing a display device and a method of manufacturing a display device, the ink IK may be discharged to correspond to a preset impact position as much as possible, by individually controlling each nozzle 1151.

In the apparatus 1 for manufacturing a display device and a method of manufacturing a display device, a display device with a precise pattern may be manufactured promptly and precisely.

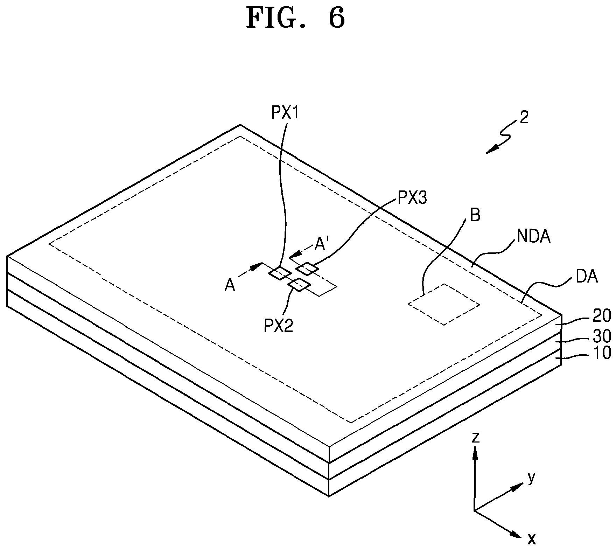

FIG. 6 is a perspective view illustrating a display device 2 according to an embodiment.

Referring to FIG. 6, the display device 2 may display an image. The display device 2 may provide an image through a plurality of sub-pixels disposed in a display area DA. Each of the plurality of sub-pixels of the display device 2 may be an area in which light of a certain color may be emitted. The display device 2 may display an image by using light emitted from the plurality of sub-pixels. For example, the sub-pixel may emit one of red, green, and blue light. In another example, the sub-pixel may emit one of red, green, blue, and white light.

A non-display area NDA may at least partially surround the display area DA. In an embodiment, the non-display area NDA may surround the display area DA entirely. The non-display area NDA may be an area on which no images are provided.

The display area DA may have a polygonal shape including a rectangle, as shown in FIG. 6. For example, the display area DA may have a rectangular shape having a horizontal length greater than a vertical length thereof, a rectangular shape having a horizontal length less than a vertical length thereof, or a square shape. Alternatively, the display area DA may have various shapes, such as an ellipse and a circle. In an embodiment, the display device 2 may include a display panel 10, a color conversion panel 20, and a filling layer 30. The display panel 10, the filling layer 30, and the color conversion panel 20 may be laminated in a thickness direction (e.g., z-axis direction). The display device 2 may also include a cover window disposed over the color conversion panel 20, a data driver mounted on the display panel 10 or a display circuit board, the display circuit board connected to the display panel 10, a component disposed on the display circuit board, a bracket supporting the display panel 10, a main circuit board connecting the display circuit board, a battery, and/or a lower cover disposed under the bracket. In this case, the cover window, the data driver, the display circuit board, the component, the bracket, the main circuit board, the battery, and the lower cover may be identical or similar to those described below.

The display device 2 is a device for displaying moving images or still images, and may be used for portable electronic devices, such as mobile phones, smartphones, tablet personal computers (PCs), mobile communication terminals, electronic notebooks, electronic books, portable multimedia players (PMP), navigations, and ultra-mobile PCs (UMPCs), but also as a display screen for various products such as televisions, laptop computers, monitors, billboards, and Internet of things (IoT) device. In addition, the display device 2 may also be used for wearable devices, such as smart watches, watch phones, glasses-type displays, and head-mounted displays (HMDs). In addition, the display device 2 may be used as an instrument panel for a vehicle, a center information display (CID) disposed on a center fascia or a dashboard, a room mirror display replacing side-view mirrors of a vehicle, and/or a display disposed on the rear surface of a front seat for an entertainment for passengers in the backseat of a vehicle. The display device 2 may be used as a light source, lighting, medical equipment (e.g., electronic thermometer, blood pressure monitor, blood sugar monitor, pulse measuring device, pulse wave measuring device, electrocardiogram display device, ultrasonic diagnostic device, and endoscope display device), a fish finder, various measuring devices, instruments (e.g., instruments for aircraft and ships), or a projector.

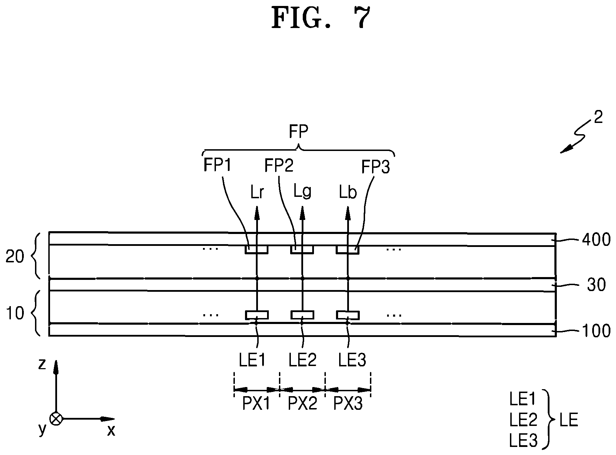

FIG. 7 is a cross-sectional view illustrating the display device 2 according to an embodiment.

Referring to FIG. 7, the display device 2 may include a first sub-pixel PX1, a second sub-pixel PX2, and a third sub-pixel PX3. The first sub-pixel PX1, the second sub-pixel PX2, and the third sub-pixel PX3 may be sub-pixels emitting light of different colors from each other. For example, the first sub-pixel PX1 may emit red light Lr, the second sub-pixel PX2 may emit green light Lg, and the third sub-pixel PX3 may emit blue light Lb.

At least one of the first sub-pixel PX1, the second sub-pixel PX2, and the third sub-pixel PX3 described above may be provided in plurality. Hereinbelow, for convenience of description, it is mainly described a case where each of the first sub-pixel PX1, the second sub-pixel PX2, and the third sub-pixel PX3 is provided in plurality.

The display device 2 may include the display panel 10, the color conversion panel 20, and the filling layer 30. The display panel 10 may include the lower substrate 100 and a light-emitting element LE. For example, the light-emitting element LE may be an organic light-emitting diode. In an embodiment, each of the first sub-pixel PX1, the second sub-pixel PX2, and the third sub-pixel PX3 may include the light-emitting element LE. For example, the first sub-pixel PX1 may include a first light-emitting element LE1. The first light-emitting element LE1 may be a first organic light-emitting diode. The second sub-pixel PX2 may include a second light-emitting element LE2. The second light-emitting element LE2 may be a second organic light-emitting diode. The third sub-pixel PX3 may include a third light-emitting element LE3. The third light-emitting element LE3 may be a third organic light-emitting diode.

The first light-emitting element LE1, the second light-emitting element LE2, and the third light-emitting element LE3 may emit light of a same color. In an embodiment, the first light-emitting element LE1, the second light-emitting element LE2, and the third light-emitting element LE3 may emit blue light.

The color conversion panel 20 may include the upper substrate 400 and a filter unit FP. In an embodiment, the filter unit FP may include a first filter unit FP1, a second filter unit FP2, and a third filter unit FP3. Light emitted from the first light-emitting element LE1 may pass through the first filter unit FP1 and may be emitted as the red light Lr. Light emitted from the second light-emitting element LE2 may pass through the second filter unit FP2 and may be emitted as the green light Lg. Light emitted from the third light-emitting element LE3 may pass through the third filter unit FP3 and may be emitted as the blue light Lb.

The filter unit FP may include a functional layer and a color filter layer. In an embodiment, the functional layer may include a first quantum dot layer, a second quantum dot layer, and a transmissive layer. In an embodiment, the color filter layer may include a first color filter, a second color filter, and a third color filter. The first filter unit FP1 may include the first quantum dot layer and the first color filter. The second filter unit FP2 may include the second quantum dot layer and the second color filter. The third filter unit FP3 may include the transmissive layer and the third color filter.

The filter unit FP may be positioned directly on the upper substrate 400. The phrase of "being positioned directly on the upper substrate" may denote manufacturing the color conversion panel 20 by forming the first color filter, the second color filter, and the third color filter directly on the upper substrate 400. Thereafter, the color conversion panel 20 may be bonded to the display panel 10 so that the first filter unit FP1, the second filter unit FP2, and the third filter unit FP3 face the first light-emitting element LE1, the second light-emitting element LE2, and the third light-emitting element LE3, respectively.

The filling layer 30 may be disposed between the display panel 10 and the color conversion panel 20. The filling layer 30 may bond the display panel 10 and the color conversion panel 20 to each other. In an embodiment, the filling layer 30 may include a thermosetting or photocurable filler. Although not shown, either one of the display panel 10 or the color conversion panel 20 may include a column spacer. For example, the display panel 10 may include a column spacer protruding toward the color conversion panel 20. In another example, the color conversion panel 20 may include a column spacer protruding toward the display panel 10. Accordingly, the plurality of light-emitting elements LE and the plurality of filter units FP may maintain a certain distance, respectively, and the display device 2 may maintain uniform luminance, depending on the position.

FIGS. 8 and 9 are cross-sectional views illustrating the display device 2 according to an embodiment. FIGS. 8 and 9 are cross-sectional views of the display device 2, taken along line A-A' of FIG. 6.

Referring to FIG. 8, the display device 2 may include the first sub-pixel PX1, the second sub-pixel PX2, and the third sub-pixel PX3 in the display area DA. The first sub-pixel PX1, the second sub-pixel PX2, and the third sub-pixel PX3 may implement different lights. For example, the first sub-pixel PX1 may implement red light, the second sub-pixel PX2 may implement green light, and the third sub-pixel PX3 may implement blue light.

In another embodiment, the display device 2 may include more sub-pixels. In FIGS. 8 and 9, the first sub-pixel PX1, the second sub-pixel PX2, and the third sub-pixel PX3 are adjacent to each other. However, in another embodiment, the first sub-pixel PX1, the second sub-pixel PX2, and the third sub-pixel PX3 may not be adjacent sub-pixels.

The display device 2 may include the display panel 10, the color conversion panel 20, and the filling layer 30. The display panel 10 may include the lower substrate 100 and a light-emitting element, the light-emitting element being disposed on the lower substrate 100 and including an intermediate layer 220. The light-emitting element may be an organic light-emitting diode. In an embodiment, the display panel 10 may include a first organic light-emitting diode OLED1, a second organic light-emitting diode OLED2, and a third organic light-emitting diode OLED3, which are disposed on the lower substrate 100. The first organic light-emitting diode OLED1, the second organic light-emitting diode OLED2, and the third organic light-emitting diode OLED3 may include the intermediate layer 220.

A laminated structure of the display panel 10 is described in detail below. In an embodiment, the display panel 10 may include the lower substrate 100, a first buffer layer 111, a bias electrode BSM, a second buffer layer 112, a thin-film transistor TFT, a storage capacitor Cst, a gate insulating layer 113, an interlayer insulating layer 115, a planarization layer 118, a light-emitting element, a pixel-defining layer 119, and an encapsulation layer 300. The thin-film transistor TFT may include a semiconductor layer Act, a gate electrode GE, a source electrode SE, and a drain electrode DE. The storage capacitor Cst may include a first electrode CE1 and a second electrode CE2.

The lower substrate 100 may include a material having a glass material, a ceramic material, a metal material, or a material with flexible or bendable properties. When the lower substrate 100 has flexible or bendable properties, the lower substrate 100 may include polymer resin, such as polyethersulfone, polyacrylate, polyetherimide, polyethylene naphthalate, polyethylene terephthalate, polyphenylene sulfide, polyarylate, polyimide, polycarbonate, and cellulose acetate propionate. The lower substrate 100 may have a single- or multi-layered structure of the above material, and when the lower substrate 100 includes a multi-layered structure, the lower substrate 100 may further include an inorganic layer. In an embodiment, the lower substrate 100 may have a structure of an organic material/inorganic material/organic material.

A barrier layer (not shown) may be further included between the lower substrate 100 and the first buffer layer 111. The barrier layer may prevent or reduce permeation of impurities from the lower substrate 100 into the semiconductor layer Act. The barrier layer may include an inorganic material, such as an oxide or a nitride, an organic material, and an organic/inorganic compound, and may have a single- or multi-layered structure of an inorganic material and an organic material.

The bias electrode BSM may be disposed on the first buffer layer 111 to correspond to the thin-film transistor TFT. In an embodiment, a voltage may be applied to the bias electrode BSM. In addition, the bias electrode BSM may prevent external light from reaching the semiconductor layer Act. Accordingly, the characteristics of the thin-film transistor TFT may be stabilized. In an embodiment, the bias electrode BSM may be omitted in some cases.

The second buffer layer 112 may be disposed on the first buffer layer 111. The semiconductor layer Act may include amorphous silicon or polysilicon. In another embodiment, the semiconductor layer Act may include an oxide of at least one selected from the group consisting of indium (In), gallium (Ga), tin (Sn), zirconium (Zr), vanadium (V), hafnium (Hf), cadmium (Cd), germanium (Ge), chrome (Cr), titanium (Ti), aluminum (Al), cesium (Cs), cerium (Ce), and zinc (Zn). In some embodiments, the semiconductor layer Act may be a Zn oxide-based material, which may be Zn oxide, In-Zn oxide, or GaIn-Zn oxide. In another embodiment, the semiconductor layer Act may be an In-Ga-Zn-O (IGZO), In-Sn-Zn-O (ITZO), or In-Ga-Sn-Zn-O (IGTZO) semiconductor in which metals such as In, Ga, and Sn are contained in zinc oxide (ZnO). The semiconductor layer Act may include a channel region, a source region, and a drain region, wherein the source region and the drain region are disposed on opposite sides of the channel region, respectively. The semiconductor layer Act may include a layer or layers.

The gate electrode GE may be disposed on the semiconductor layer Act with the gate insulating layer 113 therebetween. The gate electrode GE may at least partially overlap the semiconductor layer Act. The gate electrode GE may include molybdenum (Mo), aluminum (Al), copper (Cu), or titanium (Ti), and may have a layer or layers. For example, the gate electrode GE may be a single Mo layer. The first electrode CE1 of the storage capacitor Cst may be disposed on the same layer as a layer on which the gate electrode GE is disposed. The first electrode CE1 and the gate electrode GE may include a same material.

In FIGS. 8 and 9, the gate electrode GE of the thin-film transistor TFT and the first electrode CE1 of the storage capacitor Cst are disposed separately. However, the storage capacitor Cst may overlap the thin-film transistor TFT. In this case, the gate electrode GE of the thin-film transistor TFT may function as the first electrode CE1 of the storage capacitor Cst.

The interlayer insulating layer 115 may be provided to cover the gate electrode GE and the first electrode CE1 of the storage capacitor Cst. The interlayer insulating layer 115 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ). Zinc oxide (ZnOₓ) may include zinc oxide (ZnO) and/or zinc peroxide (ZnO₂).

The second electrode CE2 of the storage capacitor Cst, the source electrode SE, and the drain electrode DE may be disposed over the interlayer insulating layer 115. The second electrode CE2 of the storage capacitor Cst, the source electrode SE, and the drain electrode DE may include a conductive material, including Mo, Al, Cu, or Ti, and may be a layer or layers including the above materials. For example, the second electrode CE2, the source electrode SE, and the drain electrode DE may have a multi-layered structure of Ti/Al/Ti. The source electrode SE and the drain electrode DE may be connected to the source region or the drain region of the semiconductor layer Act through contact holes, respectively.

The second electrode CE2 of the storage capacitor Cst may overlap the first electrode CE1 with the interlayer insulating layer 115 therebetween to constitute the storage capacitor Cst. The interlayer insulating layer 115 may function as a dielectric layer of the storage capacitor Cst.

The planarization layer 118 may be disposed on the second electrode CE2 of the storage capacitor Cst, the source electrode SE, and the drain electrode DE. In the planarization layer 118, a film including an organic material may be formed as a layer or layers, so that a flat upper surface may be provided. The planarization layer 118 may include general-purpose polymers, such as benzocyclobutene (BCB), polyimide, hexamethyldisiloxane (HMDSO), polymethylmethacrylate (PMMA) and polystyrene (PS), polymer derivatives having a phenol-based group, acryl-based polymers, imide-based polymers, arylic ether-based polymers, amide-based polymers, fluorine-based polymers, p-xylene-based polymers, vinyl alcohol-based polymers, and any blends thereof.

A light-emitting element may be disposed on the planarization layer 118. The light-emitting element may include a pixel electrode, the intermediate layer 220, and an opposite electrode 230. In an embodiment, the first organic light-emitting diode OLED1, the second organic light-emitting diode OLED2, and the third organic light-emitting diode OLED3 may be disposed on the planarization layer 118. The first organic light-emitting diode OLED1, the second organic light-emitting diode OLED2, and the third organic light-emitting diode OLED3 may include a first sub-pixel electrode 210R, a second sub-pixel electrode 210G, and a third sub-pixel electrode 210B, respectively. In an embodiment, the first organic light-emitting diode OLED1, the second organic light-emitting diode OLED2, and the third organic light-emitting diode OLED3 may commonly include the intermediate layer 220 and the opposite electrode 230.

The first sub-pixel electrode 210R, the second sub-pixel electrode 210G, and the third sub-pixel electrode 210B may be disposed on the planarization layer 118. The first sub-pixel electrode 210R, the second sub-pixel electrode 210G, and the third sub-pixel electrode 210B may be connected to the thin-film transistor TFT. The first sub-pixel electrode 210R, the second sub-pixel electrode 210G, and the third sub-pixel electrode 210B may be (semi-)light-transmitting electrodes or reflective electrodes. In some embodiments, the first sub-pixel electrode 210R, the second sub-pixel electrode 210G, and the third sub-pixel electrode 210B may have a reflective layer and a transparent or translucent electrode layer formed on the reflective layer, wherein the reflective layer includes silver (Ag), magnesium (Mg), Al, platinum (Pt), palladium (Pd), gold (Au), nickel (Ni), neodymium (Nd), iridium (Ir), Cr, and any compounds or mixtures thereof. The transparent or translucent electrode layer may have at least one selected from the group consisting of indium tin oxide (ITO), indium zinc oxide (IZO), ZnO, In₂O₃, IGO, and AZO. In some embodiments, the first sub-pixel electrode 210R, the second sub-pixel electrode 210G, and the third sub-pixel electrode 210B may have a three-layer structure of ITO/Ag/ITO.

The pixel-defining layer 119 may be disposed on the planarization layer 118. The pixel-defining layer 119 may have openings that respectively expose central portions of the first sub-pixel electrode 210R, the second sub-pixel electrode 210G, and the third sub-pixel electrode 210B. The pixel-defining layer 119 may cover each of edges of the first sub-pixel electrode 210R, the second sub-pixel electrode 210G, and the third sub-pixel electrode 210B. The pixel-defining layer 119 may increase a distance between edges of the first sub-pixel electrode 210R, the second sub-pixel electrode 210G, and the third sub-pixel electrode 210B and the opposite electrode 230 over the first sub-pixel electrode 210R, the second sub-pixel electrode 210G, and the third sub-pixel electrode 210B, thereby preventing an arc from occurring on the edges of the first sub-pixel electrode 210R, the second sub-pixel electrode 210G, and the third sub-pixel electrode 210B. The pixel-defining layer 119 may include one or more organic insulating materials selected from the group consisting of polyimide, polyamide, acrylic resin, BCB, and phenolic resin, and may be formed by spin coating, for example.

The intermediate layers 220 of the first organic light-emitting diode OLED1, the second organic light-emitting diode OLED2, and the third organic light-emitting diode OLED3 may include an emission layer, which is an organic material including a fluorescent or phosphorous material emitting one of red, green, blue, and white light. The intermediate layer 220 may further include a metal-containing compound, such as an organic metal compound, and an inorganic material, such as quantum dots, in addition to various organic materials. The intermediate layer 220 may be a low-molecular weight organic material or a polymer organic material. A functional layer, such as a hole transport layer (HTL), a hole injection layer (HIL), an electron transport layer (ETL), and an electron injection layer (ElL), may be selectively further disposed under and over the emission layer of the intermediate layer 220. In FIGS. 8 and 9, the intermediate layer 220 is integrally provided as one body across the first sub-pixel electrode 210R, the second sub-pixel electrode 210G, and the third sub-pixel electrode 210B. However, one or more embodiments are not limited thereto, and various modifications may be made, such as the intermediate layer 220 being disposed to correspond to each of the first sub-pixel electrode 210R, the second sub-pixel electrode 210G, and the third sub-pixel electrode 210B.

The intermediate layer 220 may include a layer which is integrally provided as one body across the first sub-pixel electrode 210R, the second sub-pixel electrode 210G, and the third sub-pixel electrode 210B. However, if necessary, the intermediate layer 220 may include a layer patterned to correspond to each of the first sub-pixel electrode 210R, the second sub-pixel electrode 210G, and the third sub-pixel electrode 210B. In any case, the intermediate layer 220 may include a first-color emission layer. The first-color emission layer may be integrally provided as one body across the first sub-pixel electrode 210R, the second sub-pixel electrode 210G, and the third sub-pixel electrode 210B, and if necessary, may be patterned to correspond to each of the first sub-pixel electrode 210R, the second sub-pixel electrode 210G, and the third sub-pixel electrode 210B. The first-color emission layer may emit light in a first wavelength band, for example, light of a wavelength between about 450 nm to about 495 nm.

The opposite electrode 230 may be disposed on the intermediate layer 220 to correspond to the first sub-pixel electrode 210R, the second sub-pixel electrode 210G, and the third sub-pixel electrode 210B. The opposite electrode 230 may be integrally provided as one body in a plurality of organic light-emitting diodes. In some embodiments, the opposite electrode 230 may be a transparent or translucent electrode, and may include a metal thin film with a low work function, including lithium (Li), calcium (Ca), Al, Ag, Mg, and any compounds or mixtures thereof. The opposite electrode 230 may include a multi-layer structure such as lithium fluoride (LiF)/Ca and LiF/Al. In addition, a transparent conductive oxide film, including ITO, IZO, ZnO, or In₂O₃, may be further disposed on the metal thin film.

In an embodiment, first light may be generated in a first emission area EA1 of the first organic light-emitting diode OLED1 and emitted to the outside. The first emission area EA1 may be defined as a portion of the first sub-pixel electrode 210R exposed by an opening defined in the pixel-defining layer 119. Second light may be generated in a second emission area EA2 of the second organic light-emitting diode OLED2 and emitted to the outside. The second emission area EA2 may be defined as a portion of the second sub-pixel electrode 210G exposed by an opening defined in the pixel-defining layer 119. Third light may be generated in a third emission area EA3 of the third organic light-emitting diode OLED3 and emitted to the outside. The third emission area EA3 may be defined as a portion of the third sub-pixel electrode 210B exposed by an opening defined in the pixel-defining layer 119.

The first emission area EA1, the second emission area EA2, and the third emission area EA3 may be spaced apart from one another. An area of the display area DA other than the first emission area EA1, the second emission area EA2, and the third emission area EA3 may be a non-emission area. The first emission area EA1, the second emission area EA2, and the third emission area EA3 may be separated by the non-emission area. In a plan view (i.e., when viewed in a plan view), the first emission area EA1, the second emission area EA2, and the third emission area EA3 may be in various arrangements, such as a stripe arrangement and a PenTile^{®} arrangement. In a plan view, a shape of the first emission area EA1, a shape of the second emission area EA2, and a shape of the third emission area EA3 may each be one of a polygonal shape, a circular shape, and an elliptical shape.

A spacer (not shown) may be further included on the pixel-defining layer 119 to prevent a mask from being imprinted. The spacer and the pixel-defining layer 119 may be integrally provided as one body. For example, the spacer and the pixel-defining layer 119 may be simultaneously formed in the same process by using a halftone mask process.

The encapsulation layer 300 may be disposed on a display element and may cover the display element. The first organic light-emitting diode OLED1, the second organic light-emitting diode OLED2, and the third organic light-emitting diode OLED3 may be easily damaged by moisture or oxygen from the outside, the first organic light-emitting diode OLED1, the second organic light-emitting diode OLED2, and the third organic light-emitting diode OLED3 may be covered and protected by the encapsulation layer 300. The encapsulation layer 300 may cover the display area DA and extend out of the display area DA. The encapsulation layer 300 may include at least one organic encapsulation layer and at least one inorganic encapsulation layer. For example, the encapsulation layer 300 may include the first inorganic encapsulation layer 310, an organic encapsulation layer 320, and a second inorganic encapsulation layer 330.

Because the first inorganic encapsulation layer 310 extends along a structure thereunder, an upper surface of the first inorganic encapsulation layer 310 may not be flat. The organic encapsulation layer 320 covers the first inorganic encapsulation layer 310, and unlike the first inorganic encapsulation layer 310, an upper surface of the organic encapsulation layer 320 may be approximately flat.

The first inorganic encapsulation layer 310 and the second inorganic encapsulation layer 330 may include at least one inorganic material from among Al₂O₃, TiO₂, Ta₂O₅, HfO₂, ZnOₓ, SiO₂, SiNₓ, and SiON. ZnOₓ may include ZnO and/or ZnO₂. The organic encapsulation layer 320 may include a polymer-based material. The polymer-based material may include acryl-based resin, epoxy-based resin, polyimide, and polyethylene. In an embodiment, the organic encapsulation layer 320 may include acrylate.

Through the multi-layered structure of the encapsulation layer 300 described above, cracks may be prevented from occurring in the encapsulation layer 300 from connecting between the first inorganic encapsulation layer 310 and the organic encapsulation layer 320 or between the organic encapsulation layer 320 and the second inorganic encapsulation layer 330. Through the above, the formation of a passage through which moisture or oxygen from the outside permeates into the display area DA may be prevented or reduced. Although not shown, if necessary, other layers such as a capping layer may be positioned between the first inorganic encapsulation layer 310 and the opposite electrode 230.

The color conversion panel 20 may include the upper substrate 400, the color filter layer 500, the refractive layer RL, a first capping layer CL1, a bank 600, a functional layer 700, and a second capping layer CL2. The upper substrate 400 may be disposed on the lower substrate 100 with a light-emitting element therebetween. The upper substrate 400 may be disposed on the first organic light-emitting diode OLED1, the second organic light-emitting diode OLED2, and the third organic light-emitting diode OLED3.

The upper substrate 400 may include a light-transmitting area CA overlapping the light-emitting element. In an embodiment, the light-transmitting area CA may include a first light-transmitting area CA1, a second light-transmitting area CA2, and a third light-transmitting area CA3. In a plan view, the first light-transmitting area CA1 may overlap the first organic light-emitting diode OLED1 and/or the first emission area EA1. In a plan view, the second light-transmitting area CA2 may overlap the second organic light-emitting diode OLED2 and/or the second emission area EA2. In a plan view, the third light-transmitting area CA3 may overlap the third organic light-emitting diode OLED3 and/or the third emission area EA3.

The light-transmitting area CA described above may be defined by a color filter. For example, the light-transmitting area CA may refer to an area in which only one color filter is disposed. In an embodiment, only a first color filter 510 may be disposed in the first light-transmitting area CA1. In addition, only a second color filter 520 may be disposed in the second light-transmitting area CA2. Only a third color filter 530 may be disposed in the third light-transmitting area CA3. In this case, the first light-transmitting area CA1 and the second light-transmitting area CA2 may be defined by the third color filter 530. In other words, the first light-transmitting area CA1 and the second light-transmitting area CA2 may be defined by a pattern area, which is an opened portion of the third color filter 530.

The upper substrate 400 may include glass, metal, or polymer resin. When the upper substrate 400 has flexible or bendable properties, the upper substrate 400 may include polymer resin, such as polyethersulfone, polyacrylate, polyetherimide, polyethylene naphthalate, polyethylene terephthalate, polyphenylene sulfide, polyarylate, polyimide, polycarbonate, and cellulose acetate propionate. In an embodiment, the upper substrate 400 may have a multi-layered structure including two layers and a barrier layer therebetween, wherein the two layers each include polymer resin as described above, and the barrier layer includes an inorganic material, such as SiO₂, SiNₓ, and SiON.

The color filter layer 500 may be disposed on a lower surface of the upper substrate 400 in a direction from the upper substrate 400 toward the lower substrate 100. The color filter layer 500 may include the first color filter 510, the second color filter 520, and the third color filter 530. The first color filter 510 may be disposed in the first light-transmitting area CA1. The second color filter 520 may be disposed in the second light-transmitting area CA2. The third color filter 530 may be disposed in the third light-transmitting area CA3. The first color filter 510, the second color filter 520, and the third color filter 530 may include a photosensitive resin material. Each of the first color filter 510, the second color filter 520, and the third color filter 530 may include dye that exhibits a unique color. The first color filter 510 may allow only light of a wavelength of about 630 nm to about 780 nm to pass therethrough, the second color filter 520 may allow only light of a wavelength of about 495 nm to about 570 nm to pass therethrough, and the third color filter 530 may allow only light of a wavelength of about 450 nm to about 495 nm to pass therethrough.

The color filter layer 500 may reduce reflection of external light in the display device 2. For example, when external light reaches the first color filter 510, only light of a preset wavelength as described above may pass through the first color filter 510, and light of other wavelengths may be absorbed by the first color filter 510. Accordingly, only light of the preset wavelength from among external light incident on the display device 2 may pass through the first color filter 510, and some of the light passing through the first color filter 510 may be reflected from the opposite electrode 230 and/or the first sub-pixel electrode 210R thereunder, and emitted to the outside. Because only some of the external light incident on a place where the first sub-pixel PX1 is positioned is reflected to the outside, reflection of the external light may be reduced. The description above may also be applicable to the second color filter 520 and the third color filter 530.

The first color filter 510, the second color filter 520, and the third color filter 530 may overlap each other. The first color filter 510, the second color filter 520, and the third color filter 530 may overlap one another between one of the light-transmitting area CA and another one of the light-transmitting area CA. For example, the first color filter 510, the second color filter 520, and the third color filter 530 may overlap one another between the first light-transmitting area CA1 and the second light-transmitting area CA2. In this case, the third color filter 530 may be disposed between the first light-transmitting area CA1 and the second light-transmitting area CA2. The first color filter 510 may extend from the first light-transmitting area CA1 and overlap the third color filter 530. The second color filter 520 may extend from the second light-transmitting area CA2 and overlap the third color filter 530.

The first color filter 510, the second color filter 520, and the third color filter 530 may overlap one another between the second light-transmitting area CA2 and the third light-transmitting area CA3. The first color filter 510 may be disposed between the second light-transmitting area CA2 and the third light-transmitting area CA3. The second color filter 520 may extend from the second light-transmitting area CA2 and overlap the first color filter 510. The third color filter 530 may extend from the third light-transmitting area CA3 and overlap the first color filter 510.

The first color filter 510, the second color filter 520, and the third color filter 530 may overlap one another between the third light-transmitting area CA3 and the first light-transmitting area CA1. The second color filter 520 may be disposed between the third light-transmitting area CA3 and the first light-transmitting area CA1. The third color filter 530 may extend from the third light-transmitting area CA3 and overlap the second color filter 520. The first color filter 510 may extend from the first light-transmitting area CA1 and overlap the second color filter 520.

The first color filter 510, the second color filter 520, and the third color filter 530 may overlap each other and constitute a light-blocking unit BP. Accordingly, the color filter layer 500 may prevent or reduce color mixing even without a separate light-shielding member.

In an embodiment, the third color filter 530 may be first laminated on the upper substrate 400. This is because external light incident on the outside of the upper substrate 400 is partially absorbed by the third color filter 530 so that the reflectivity of the display device 2 is reduced, and light reflected by the third color filter 530 is rarely visible to the user.

The refractive layer RL may be disposed in the light-transmitting area CA. The refractive layer RL may be disposed in each of the first light-transmitting area CA1, the second light-transmitting area CA2, and the third light-transmitting area CA3. The refractive layer RL may include an organic material. In an embodiment, a refractive index of the refractive layer RL may be less than a refractive index of the first capping layer CL1. In an embodiment, the refractive index of the refractive layer RL may be less than a refractive index of the color filter layer 500. Accordingly, the refractive layer RL may condense light.

The first capping layer CL1 may be disposed on the refractive layer RL and the color filter layer 500. In an embodiment, the first capping layer CL1 may be disposed between the color filter layer 500 and the functional layer 700. The first capping layer CL1 may protect the refractive layer RL and the color filter layer 500. The first capping layer CL1 may prevent or reduce damage or contamination of the refractive layer RL and/or the color filter layer 500 due to permeation of impurities, such as moisture and air from the outside. The first capping layer CL1 may include an inorganic material.

The bank 600 may be disposed on the first capping layer CL1. In an embodiment, the bank 600 may be disposed on the upper substrate 400. The bank 600 may be disposed on a lower surface of the upper substrate 400 facing the lower substrate 100. The bank 600 may include an organic material. In some cases, the bank 600 may include a light-shielding material so as to function as a light-shielding layer. The light-shielding material may include, for example, at least one of black pigment, black dye, black particles, and metal particles.

The bank 600 may have a plurality of openings. For example, the bank 600 may have an opening COP. The opening COP may overlap the light-transmitting area CA. In an embodiment, the plurality of openings COP may overlap the light-transmitting area CA. For example, a first opening COP1 may overlap the first light-transmitting area CA1. A second opening COP2 may overlap the second light-transmitting area CA2. A third opening COP3 may overlap the third light-transmitting area CA3.

The functional layer 700 may be disposed in the opening COP. The functional layer 700 may fill the opening COP. In an embodiment, the functional layer 700 may include at least one of a color conversion material and a scatterer. In an embodiment, the color conversion material may be quantum dots. In an embodiment, the functional layer 700 may include a first quantum dot layer 710, a second quantum dot layer 720, and a transmissive layer 730.

The first quantum dot layer 710 may be disposed in the first opening COP1. The first quantum dot layer 710 may overlap the first light-transmitting area CA1. The first quantum dot layer 710 may fill the first opening COP1. The first quantum dot layer 710 may overlap the first emission area EA1. The first sub-pixel PX1 may include the first organic light-emitting diode OLED1 and the first quantum dot layer 710.

The first quantum dot layer 710 may convert light in a first wavelength band generated in the intermediate layer 220 on the first sub-pixel electrode 210R, into light in a second wavelength band. For example, when light of a wavelength of about 450 nm to about 495 nm is generated in the intermediate layer 220 on the first sub-pixel electrode 210R, the first quantum dot layer 710 may convert the light into light of a wavelength of about 630 nm to about 780 nm. Accordingly, light of the wavelength of about 630 nm to about 780 nm may be emitted from the first sub-pixel PX1 to the outside through the upper substrate 400. In an embodiment, the first quantum dot layer 710 may include a first quantum dot QD1, a first scatterer SC1, and a first base resin BR1. The first quantum dot QD1 and the first scatterer SC1 may be dispersed in the first base resin BR1.

The second quantum dot layer 720 may be disposed in the second opening COP2. The second quantum dot layer 720 may overlap the second light-transmitting area CA2. The second quantum dot layer 720 may fill the second opening COP2. The second quantum dot layer 720 may overlap the second emission area EA2. The second sub-pixel PX2 may include the second organic light-emitting diode OLED2 and the second quantum dot layer 720.

The second quantum dot layer 720 may convert light in the first wavelength band generated in the intermediate layer 220 on the second sub-pixel electrode 210G, into light in a third wavelength band. For example, when light of the wavelength of about 450 nm to about 495 nm is generated in the intermediate layer 220 on the second sub-pixel electrode 210G, the second quantum dot layer 720 may convert the light into light of the wavelength of about 495 nm to about 570 nm. Accordingly, light of the wavelength of about 495 nm to about 570 nm may be emitted from the second sub-pixel PX2 to the outside through the upper substrate 400. In an embodiment, the second quantum dot layer 720 may include a second quantum dot QD2, a second scatterer SC2, and a second base resin BR2. The second quantum dot QD2 and the second scatterer SC2 may be dispersed in the second base resin BR2.

The transmissive layer 730 may be disposed in the third opening COP3. The transmissive layer 730 may overlap the third light-transmitting area CA3. The transmissive layer 730 may fill the third opening COP3. The transmissive layer 730 may overlap the third emission area EA3. The third sub-pixel PX3 may include the third organic light-emitting diode OLED3 and the transmissive layer 730.

The transmissive layer 730 may emit light generated in the intermediate layer 220 on the third sub-pixel electrode 210B, to the outside without wavelength conversion. For example, when light of the wavelength of about 450 nm to about 495 nm is generated in the intermediate layer 220 on the third sub-pixel electrode 210B, the transmissive layer 730 may emit the light to the outside without wavelength conversion. In an embodiment, the transmissive layer 730 may include a third scatterer SC3 and a third base resin BR3. The third scatterer SC3 may be dispersed in the third base resin BR3. In an embodiment, the transmissive layer 730 may not include quantum dots.

At least one of the first quantum dot QD1 and the second quantum dot QD2 may include a semiconductor material, such as cadmium sulfide (CdS), cadmium teleride (CdTe), zinc sulfide (ZnS), and indium phosphide (InP). The quantum dot may have a size of several nanometers, and a wavelength of light after conversion may vary depending on the size of the quantum dot.

In an embodiment, a core of the quantum dot may be selected from among a Group II-VI compound, a Group III-V compound, a Group IV- IV compound, a Group IV compound, and any combinations thereof.

The Group II-VI compound may be selected from the group consisting of: a binary compound selected from the group consisting of CdSe, CdTe, ZnS, ZnSe, ZnTe, ZnO, HgS, HgSe, HgTe, MgSe, MgS, and any mixtures thereof; a ternary compound selected from the group consisting of AgInS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and any mixtures thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and any mixtures thereof.

The Group III-V compound may be selected from the group consisting of: a binary compound selected from the group consisting of GaN, GaP, GaAs, GaSb, AlN, AlP, AlAs, AlSb, InN, InP, InAs, InSb, and any mixtures thereof; a ternary compound selected from the group consisting of GaNP, GaNAs, GaNSb, GaPAs, GaPSb, AINP, AlNAs, AlNSb, AlPAs, AlPSb, InGaP, InNP, InNAs, InNSb, InPAs, InPSb, and any mixtures thereof; and a quaternary compound selected from the group consisting of GaAlNP, GaAINAs, GaAINSb, GaAlPAs, GaAlPSb, GalnNP, GalnNAs, GaInNSb, GalnPAs, GalnPSb, InAlP, InAlNAs, InAlNSb, InAlPAs, InAlPSb, and any mixtures thereof.

The Group IV-VI compound may be selected from the group consisting of: a binary compound selected from the group consisting of SnS, SnSe, SnTe, PbS, PbSe, PbTe, and any mixtures thereof; a ternary compound selected from the group consisting of SnSeS, SnSeTe, SnSTe, PbSeS, PbSeTe, PbSTe, SnPbS, SnPbSe, SnPbTe, and any mixtures thereof; and a quaternary compound selected from the group consisting of SnPbSSe, SnPbSeTe, SnPbSTe, and any mixtures thereof. The Group IV element may be selected from the group consisting of silicon (Si), germanium (Ge), and any mixtures thereof. The Group IV compound may be a binary compound selected from the group consisting of SiC, SiGe, and any mixtures thereof.

The binary compound, the ternary compound, or the quaternary compound may be present in a particle at a uniform concentration, or may be present in the same particle while being divided into states with partially different concentration distributions. In addition, the quantum dot may have a core/shell structure in which a quantum dot surrounds another quantum dot. An interface between the core and the shell may have a concentration gradient in which a concentration of elements present in the shell decreases toward the center.

In some embodiments, the quantum dot may have a core/shell structure including a core and a shell surrounding the core. For example, the core includes the nanocrystals described above. The shell of the quantum dot may serve as a protective layer for maintaining semiconductor characteristics by preventing chemical modification of the core, and/or as a charging layer for imparting electrophoretic characteristics to the quantum dot. The shell may be a layer or layers. An interface between the core and the shell may have a concentration gradient in which a concentration of elements present in the shell decreases toward the center. Examples of the shell of the quantum dot may include a metal or non-metal oxide, a semiconductor compound, or any combinations thereof.

For example, the metal or non-metal oxide may include a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO, or a ternary compound, such as MgAl₂O₄, CoFe₂O₄, NiFe₂O₄, and CoMn₂O₄ However, embodiments of the present disclosure are not limited thereto.

Examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and AlSb. However, the present disclosure is not limited thereto.

The quantum dot may have a full width of half maximum (FWHM) of an emission wavelength spectrum of about 45 nm or less, about 40 nm or less, or about 30 nm or less, and color purity or color reproducibility may be improved within this range. In addition, light emitted through such quantum dots is emitted in all directions, which may improve the optical viewing angle.

A shape of a quantum dot is not particularly limited to a shape commonly used in the art. For example, a shape such as a spherical shape, a pyramidal shape, a multi-arm shape, a cubic nanoparticle, a nanotube, a nanowire, a nanofiber, and a nanoplatelet may be used.

The quantum dot may adjust a color of emitted light, depending on a particle size, and accordingly, the quantum dot may have various emission colors such as blue, red, and green.

The first scatterer SC1, the second scatterer SC2, and the third scatterer SC3 may scatter light so that more light may be emitted. The first scatterer SC1, the second scatterer SC2, and the third scatterer SC3 may increase light emission efficiency. At least one of the first scatterer SC1, the second scatterer SC2, and the third scatterer SC3 may be any material among metal and metal oxide for evenly scattering light. For example, at least one of the first scatterer SC1, the second scatterer SC2, and the third scatterer SC3 may be at least one of TiO₂, ZrO₂, Al₂O₃, In₂O₃, ZnO, SnO₂, Sb₂O₃, and ITO. In addition, at least one of the first scatterer SC1, the second scatterer SC2, and the third scatterer SC3 may have a refractive index of 1.5 or more. Accordingly, the light emission efficiency of the functional layer 700 may be improved. In some embodiments, at least one of the first scatterer SC1, the second scatterer SC2, and the third scatterer SC3 may be omitted.

The first base resin BR1, the second base resin BR2, and the third base resin BR3 may include a light-transmitting material. For example, at least one of the first base resin BR1, the second base resin BR2, and the third base resin BR3 may include polymer resin, such as acrylic, BCB, and HMDSO.

The second capping layer CL2 may be disposed on the bank 600 and the functional layer 700. The second capping layer CL2 may protect the bank 600 and the functional layer 700. The second capping layer CL2 may prevent or reduce damage or contamination of the bank 600 and/or the functional layer 700 due to permeation of impurities, such as moisture and air from the outside. The second capping layer CL2 may include an inorganic material.

In the display device 2 described above, the first sub-pixel PX1 may emit light in a second wavelength band to the outside, the second sub-pixel PX2 may emit light in a third wavelength band to the outside, and the third sub-pixel PX3 may emit light in a first wavelength band to the outside. In other words, the display device 2 may display a full color image.

The filling layer 30 may be disposed between the display panel 10 and the color conversion panel 20. In an embodiment, the filling layer 30 may be disposed between the encapsulation layer 300 and the bank 600. The filling layer 30 may have a buffering effect against external pressure or external impact. The filling layer 30 may include a filler. In an embodiment, the filling layer 30 may include a thermosetting or photocurable filler. The filler may include an organic material, such as methyl silicone, phenyl silicone, and polyimide. However, one or more embodiments are not limited thereto, and the filler may include an organic sealant, such as urethane-based resin, epoxy-based resin, and acrylic-based resin, an inorganic sealant, or silicone.

Referring to FIG. 9, either one of the display panel 10 and the color conversion panel 20 may include a column spacer 800. In an embodiment, the color conversion panel 20 may include the column spacer 800. In another embodiment, the display panel 10 may include the column spacer 800. Hereinbelow, a case where the color conversion panel 20 includes the column spacer 800 is mainly described in detail. The column spacer 800 may be disposed on the bank 600 to face the lower substrate 100. The column spacer 800 may separate the encapsulation layer 300 and the bank 600 from each other. The column spacer 800 may pass through the filling layer 30. The column spacer 800 may include an organic material. In an embodiment, the column spacer 800 may include an acrylic-based material.

The column spacer 800 may separate a light-emitting element and the functional layer 700 from each other at a uniform interval. Accordingly, the filling layer 30 may be disposed with a uniform thickness in the display area DA. In other words, a distance between the first organic light-emitting diode OLED1 and the first quantum dot layer 710 may be substantially equal to a distance between the second organic light-emitting diode OLED2 and the second quantum dot layer 720. In addition, the distance between the second organic light-emitting diode OLED2 and the second quantum dot layer 720 may be substantially identical to a distance between the third organic light-emitting diode OLED3 and the transmissive layer 730. When the column spacer 800 is omitted, unlike in the present embodiment, a plurality of light-emitting elements and a functional layer 700 may not maintain a uniform interval. For example, a thickness of the filling layer 30 in the first light-transmitting area CA1 may be different from a thickness of the filling layer 30 in the second light-transmitting area CA2. In this case, a luminance of light emitted from the first organic light-emitting diode OLED1 and passing through the filling layer 30 overlapping the first light-transmitting area CA1 may be different from a luminance of light emitted from the second organic light-emitting diode OLED2 and passing through the filling layer 30 overlapping the second light-transmitting area CA2. In the present embodiment, the column spacer 800 may be disposed to pass through the filling layer 30 and may space the light-emitting element and the functional layer 700 apart at a uniform interval. In addition, due to the filling layer 30, a phenomenon in which the luminance varies depending on the position in the display area DA may be prevented or reduced.

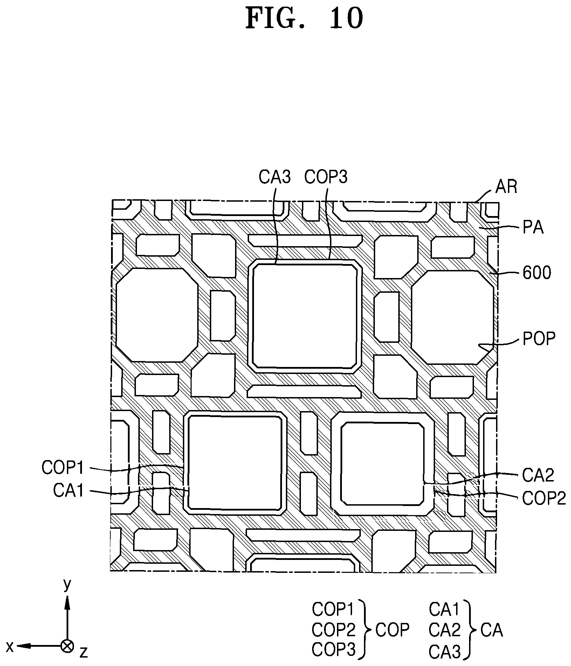

FIG. 10 is a plan view illustrating a portion of the color conversion panel 20 according to an embodiment. FIG. 10 is a plan view of region B of FIG. 6.

Referring to FIGS. 8 and 10, the color conversion panel 20 may include the upper substrate 400, the bank 600, and the functional layer 700. The upper substrate 400 may include the light-transmitting area CA and a peripheral area PA. The light-transmitting area CA may be an area in which the color filter layer 500 is disposed. For example, the light-transmitting area CA may be an area in which only one color filter is disposed. The peripheral area PA may be a light-shielding area. In an embodiment, the light-transmitting area CA may include the first light-transmitting area CA1, the second light-transmitting area CA2, and the third light-transmitting area CA3. The first light-transmitting area CA1, the second light-transmitting area CA2, and the third light-transmitting area CA3 may be spaced apart from each other. In FIG. 10, a center of the first light-transmitting area CA1, a center of the second light-transmitting area CA2, and a center of the third light-transmitting area CA3 may be arranged to constitute vertices of an imaginary triangle, respectively. In this case, only the first color filter 510 may be disposed in the first light-transmitting area CA1, only the second color filter 520 may be disposed in the second light-transmitting area CA2, and only the third color filter 530 may be disposed in the third light-transmitting area CA3.

A planar shape of at least one of the first light-transmitting area CA1, the second light-transmitting area CA2, and the third light-transmitting area CA3 described above may be a rectangular or square shape. Hereinbelow, for convenience of description, a case is mainly described in which the planar shape of the first light-transmitting area CA1, the planar shape of the second light-transmitting area CA2, and the planar shape of the third light-transmitting area CA3 are all square shapes.

In an embodiment, at least one corner of the planar shape of the first light-transmitting area CA1, the planar shape of the second light-transmitting area CA2, and the planar shape of the third light-transmitting area CA3 may be round or chamfered. In another embodiment, at least one corner of the planar shape of the first light-transmitting area CA1, the planar shape of the second light-transmitting area CA2, and the planar shape of the third light-transmitting area CA3 may not be chamfered. Hereinbelow, for convenience of description, a case is mainly described in which a corner of the planar shape of the first light-transmitting area CA1, a corner of the planar shape of the second light-transmitting area CA2, and a corner of the planar shape of the third light-transmitting area CA3 are all chamfered.

The first light-transmitting area CA1 and the second light-transmitting area CA2 described above may be disposed in the same column or row. In other words, the first light-transmitting area CA1 and the second light-transmitting area CA2 may be arranged in a row in a direction (e.g., one of the x-axis direction and the y-axis direction of FIG. 10). In this case, the first light-transmitting area CA1 and the second light-transmitting area CA2 may each be provided in plurality, and some of the plurality of first light-transmitting areas CA1 and some of the plurality of second light-transmitting areas CA2 may be alternately disposed in the direction. In addition, another of the plurality of first light-transmitting areas CA1 and another of the plurality of second light-transmitting areas CA2 may be arranged in a row in a another direction (e.g., the other one of the x-axis direction and the y-axis direction of FIG. 10). The third light-transmitting area CA3 may be spaced apart from the first light-transmitting area CA1 and the second light-transmitting area CA2 in the other direction. The third light-transmitting area CA3 may be disposed on a line different from a line on which the first light-transmitting area CA1 and the second light-transmitting area CA2 are arranged. In other words, in a plan view, the center of the first light-transmitting area CA1, the center of the second light-transmitting area CA2, and the center of the third light-transmitting area CA3 may constitute a triangle. In this case, the plurality of third light-transmitting areas CA3 may be arranged in a row in the first direction and the second direction, and the first direction and the second direction may be perpendicular to each other.

The peripheral area PA may be disposed outside the light-transmitting area CA. The peripheral area PA may surround at least a portion of the light-transmitting area CA. In an embodiment, the peripheral area PA may surround the light-transmitting area CA entirely. The peripheral area PA may surround the first light-transmitting area CA1 entirely. The peripheral area PA may surround the second light-transmitting area CA2 entirely. The peripheral area PA may surround the third light-transmitting area CA3 entirely.

The bank 600 may have the opening COP and a peripheral opening POP. In an embodiment, an area of the opening COP may be greater than an area of the peripheral opening POP. The opening COP may overlap the light-transmitting area CA. The opening COP may be filled with the functional layer 700. The opening COP may include the first opening COP1, the second opening COP2, and the third opening COP3. The first opening COP1 may be disposed in the first light-transmitting area CA1. The second opening COP2 may be disposed in the second light-transmitting area CA2. The third opening COP3 may be disposed in the third light-transmitting area CA3. In this case, an array of the opening COP may be identical to or similar to an array of the light-transmitting area CA described above.

A planar shape of at least one of the first opening COP1, the second opening COP2, and the third opening COP3 may be a square shape. Hereinbelow, for convenience of description, a case is mainly described in which the planar shape of the first opening COP1, the planar shape of the second opening COP2, and the planar shape of the third opening COP3 are all square shapes.

In the case described above, in a plan view, an edge (or inner surface) of the opening COP may not coincide with an edge of the light-transmitting area CA and may be spaced apart from the edge of the light-transmitting area CA.

The peripheral opening POP may be disposed in the peripheral area PA. The peripheral opening POP may include a plurality of peripheral openings POP. Shapes of the plurality of peripheral openings POP may include various shapes such as a polygonal shape and a circular shape. In an embodiment, in a plan view, the plurality of peripheral openings POP may surround the opening COP. For example, in a plan view, the plurality of peripheral openings POP may surround the first opening COP1. In a plan view, the plurality of peripheral openings POP may surround the second opening COP2. In a plan view, the plurality of peripheral openings POP may surround the third opening COP3.

The peripheral opening POP may be a structure for improving the reliability of the color conversion panel 20. For example, the functional layer 700 may be formed by an inkjet printing process. When the functional layer 700 is formed by discharging ink through the opening COP, a nozzle must supply the ink to the opening COP at an accurate position. When the nozzle fails to supply ink to the opening COP at the accurate position, the functional layer 700 may be formed on an upper surface of the bank 600. In this case, the functional layer 700 formed on the upper surface of the bank 600 may cause damage, such as cracks, to an encapsulation layer 300 when the color conversion panel 20 and the display panel 10 are bonded to each other. Alternatively, due to the functional layer 700 formed on the upper surface of the bank 600, a filling layer 30 may not be uniformly disposed between the display panel 10 and the color conversion panel 20.

The functional layer 700 may be disposed in the opening COP. The functional layer 700 may fill the opening COP. In an embodiment, the functional layer 700 may include at least one of a color conversion material and a scatterer. In an embodiment, the color conversion material may be quantum dots. In an embodiment, the functional layer 700 may include the first quantum dot layer 710, the second quantum dot layer 720, and the transmissive layer 730. The first quantum dot layer 710 may be disposed in the first opening COP1. The second quantum dot layer 720 may be disposed in the second opening COP2. The transmissive layer 730 may be disposed in the third opening COP3.

When the functional layer 700 described above is disposed, the apparatus for manufacturing a display device and a method of manufacturing a display device described above may be used. In this case, the openings COP may be located at positions corresponding to the respective sub-pixels. One opening COP may correspond to one discharge area. In other words, a plurality of nozzles may be disposed to overlap each other on an upper surface of one opening COP, and a nozzle providing ink to the one opening COP may be selected as described above and may supply ink.

Through the above, a material forming the functional layer 700 may be provided to each opening COP accurately.

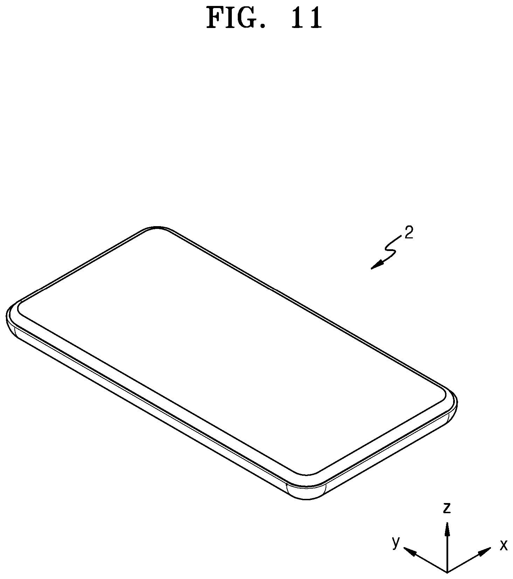

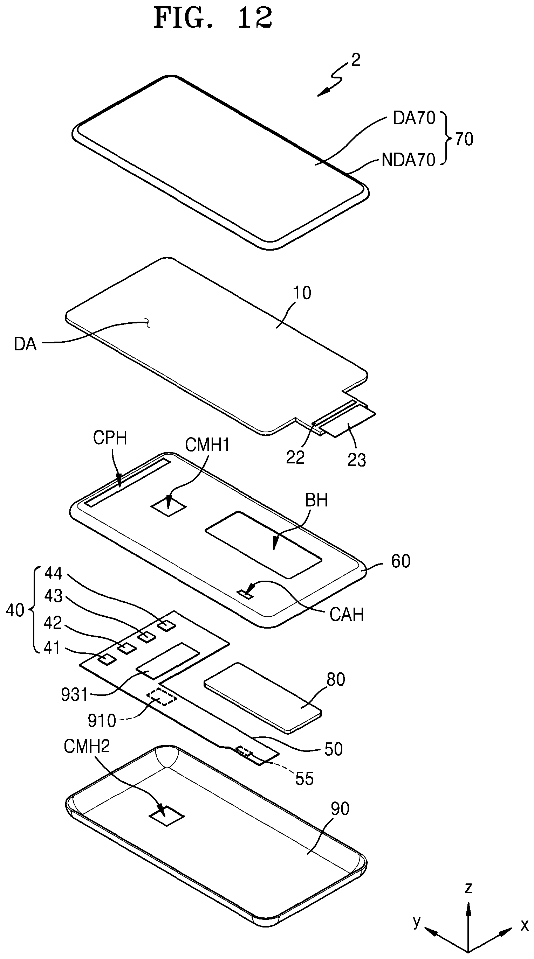

FIG. 11 is a perspective view illustrating the display device 2 according to another embodiment. FIG. 12 is an exploded perspective view illustrating the display device 2 shown in FIG. 11.

Referring to FIGS. 11 and 12, the display device 2 may include a cover window 70, the display panel 10, a data driver 22, a display circuit board 23, a bracket 60, a main circuit board 50, a battery 80, and/or a lower cover 90.

In a plan view, "left," "right" "up," and "down" refer to directions when the display panel 10 is viewed from a direction perpendicular to the display panel 10. For example, "left" refers to a -x direction, "right" refers to a +x direction, "up" refers to a +y direction, and "down" refers to a -y direction.

In a plan view, the display device 2 may appear to have an approximately rectangular shape. For example, the display device 2 may appear to have an approximately rectangular shape having a short side in the x-axis direction and a long side in the y-axis direction on a xy plane (a plane defined by the x-axis direction and y-axis direction), as shown in FIG. 11. In this case, a corner at which the short side in the x-axis direction meets the long side in the y-axis direction may form a right angle, or may have a round shape with a certain curvature. However, in a plan view, the display device 2 may have a polygonal shape other than a rectangular shape, or may have an elliptical shape or an irregular shape.

The cover window 70 may be disposed over the display panel 10 to cover an upper surface of the display panel 10. The cover window 70 may protect the upper surface of the display panel 10.

The cover window 70 may include a transmissive cover unit DA70 corresponding to the display panel 10 and a light-shielding cover unit NDA70 surrounding the transmissive cover unit DA70. The light-shielding cover unit NDA70 may include an opaque material (e.g., a colored opaque material) that blocks light. The light-shielding cover unit NDA70 may include a pattern that may be shown to a user when an image is not displayed.

The display panel 10 may be disposed under the cover window 70. The display panel 10 may overlap the transmissive cover unit DA70 of the cover window 70. The display panel 10 may include a display area DA. The display area DA is an area on which an image is displayed, and the display area DA may include an area (hereinafter referred to as "component area") that transmits light emitted from the component 40 disposed under the display panel 10. The component 40 may include sensors and cameras that use visible light, infrared light, or sound.

The display panel 10 may be a light-emitting display panel including a light-emitting diode. The light-emitting diode may be an organic light-emitting diode including an organic emission layer, or may be an inorganic light-emitting diode including an inorganic material. The inorganic light-emitting diode may include a PN junction diode including inorganic semiconductor-based materials. When a voltage is applied to a PN junction diode in the forward direction, holes and electrons may be injected, and energy generated by recombination of the holes and the electrons may be converted into light energy so that light of a certain color may be emitted. The inorganic light-emitting diode described above may have a width of several to hundreds of micrometers. The inorganic light-emitting diode may also be referred to as a micro light-emitting diode (LED).

The display panel 10 may be a rigid display panel that is not easily bendable due to the rigidity thereof, or a flexible display panel that is easily bendable, foldable, or rollable due to the flexibility thereof. For example, the display panel 10 may be a foldable display panel, a curved display panel having a bendable display surface, a bended display panel in which an area other than the display surface is bendable, a rollable display panel, or a stretchable display panel.

The display panel 10 may be a transparent display panel in which an object or a background disposed on a lower surface of the display panel 10 is visible through the upper surface of the display panel 10. Alternatively, the display panel 10 may be a reflective display panel in which an object or a background may be reflected from the upper surface of the display panel 10.

The display panel 10 described above may have a structure from the lower substrate 100 to the encapsulation layer 300 shown in FIGS. 8 and 9.

The data driver 22 may be mounted on the display panel 10 in the form of an integrated circuit (IC). However, one or more embodiments are not limited thereto, and the data driver 22 may be mounted on the display circuit board 23, for example.

The display circuit board 23 may be attached to one side of the display panel 10. The display circuit board 23 may be a flexible printed circuit board (FPCB) that is bendable, a rigid printed circuit board (PCB) that is hard and does not bend easily, or a composite printed circuit board including both the PCB and the FPCB. A touch sensor driving unit may be mounted on the display circuit board 23 described above. The touch sensor driving unit may be formed as an IC. The touch sensor driving unit may be electrically connected to touch electrodes of a touch screen layer of the display panel 10 through the display circuit board 23.

The touch screen layer of the display panel 10 may detect a touch input of a user by using at least one of various touch methods such as a resistive film method and an electrostatic capacitance method. When the touch screen layer of the display panel 10 detects the user's touch input by using the electrostatic capacitance method, the touch sensor driving unit may apply driving signals to driving electrodes among the touch electrodes, and detect voltages charged in mutual capacitances between the driving electrodes and sensing electrodes through the sensing electrodes among the touch electrodes, so that determination may be made whether the user has touched.

The user's touch may include a contact touch and a proximity touch. The contact touch refers to an object, such as a user's finger and a pen, directly touching the cover window 70 disposed on the touch screen layer. The proximity touch refers to an object, such as a user's finger and a pen, being positioned close to the cover window 70, such as hovering. The touch sensor driving unit may transmit sensor data to a main processor 910 according to the detected voltages, and the main processor 910 may analyze the sensor data to calculate touch coordinates on which a touch input has occurred.

A control unit for supplying driving voltages for driving pixels, a gate driver, and/or the data driver 22 of the display panel 10 may be disposed on the display circuit board 23.

A bracket 60 for supporting the display panel 10 may be disposed under the display panel 10. The bracket 60 may include plastic, metal, or both plastic and metal. The bracket 60 may include a first camera hole CMH1 into which a camera device 931 is inserted, a battery hole BH in which the battery 80 is disposed, a cable hole CAH through which a cable connected to the display circuit board 23 passes, and a component hole CPH corresponding to the components 40. The component hole CPH may overlap the components 40 of the main circuit board 50 when viewed from the third direction (z-axis direction). In addition, the display area DA of the display panel 10 may overlap the components 40 of the main circuit board 50 when viewed from the third direction (z-axis direction). However, if necessary, the bracket 60 may not have the component hole CPH.

The component 40 included in the display device 2 may include a first component 41, a second component 42, a third component 43, and a fourth component 44, which overlap the display panel 10. Each of the first component 41, the second component 42, the third component 43, and the fourth component 44 may include at least one of a proximity sensor, an illumination sensor, an iris sensor, a face recognition sensor, and a camera (or image sensor). The proximity sensor using infrared light may detect an object positioned close to the upper surface of the display device 2, and the illumination sensor may detect a brightness of light incident on the upper surface of the display device 2. In addition, the iris sensor may photograph a person's iris positioned on the upper surface of the display device 2, and the camera may obtain image data for the object disposed on the upper surface of the display device 2. However, the component 40 is not limited to the proximity sensor, the illumination sensor, the iris sensor, the face recognition sensor, and/or the camera, and may include other sensors.

The main circuit board 50 and the battery 80 may be disposed under the bracket 60. The main circuit board 50 may be a PCB or a FPCB.

The main circuit board 50 may include the main processor 910, the camera device 931, a main connector 55, and the components 40. The main processor 910 may be formed as an IC. If necessary, the display device 2 may include a camera device disposed under the main circuit board 50 as well as the camera device 931 disposed on the upper surface of the main circuit board 50. Each of the main processor 910 and the main connector 55 may be disposed on either one of the upper surface and the lower surface of the main circuit board 50. The main circuit board 50 described above may be electrically connected to the display circuit board 23 through the main connector 55.

The main processor 910 may control all functions of the display device 2. For example, the main processor 910 may output digital video data to the data driver 22 through the display circuit board 23 so that an image is displayed on the display panel 10. The main processor 910 may receive sensing data from the touch sensor driving unit. The main processor 910 may determine whether the user has touched, according to the sensing data, and execute an operation corresponding to the direct touch or the proximity touch of the user. The main processor 910 may be an application processor, a central processing unit, or a system chip, which include an IC.

The camera device 931 may process an image frame, such as a still image and a moving image, obtained by an image sensor in a camera mode, and output the processed image frame to the main processor 910. The camera device 931 may include at least one of a camera sensor (e.g., a charge-coupled device (CCD) or a complementary metal-oxide-semiconductor (CMOS)), a photo sensor (or image sensor), and a laser sensor.

A cable that has passed through the cable hole CAH of the bracket 60 may be connected to the main connector 55, and the main connector 55 may be electrically connected to the display circuit board 23 through the cable.

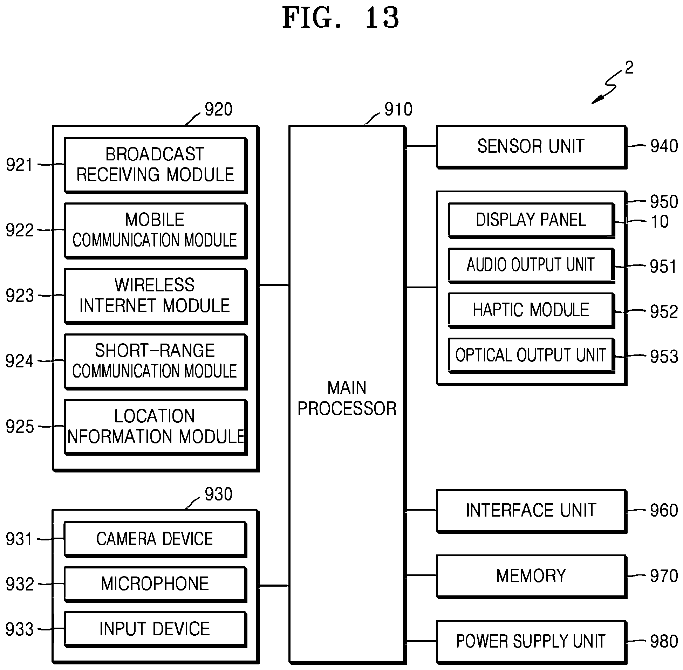

FIG. 13 is a block diagram illustrating the display device 2 shown in FIG. 6 or 11.

Referring to FIG. 13, the display device 2 may also be represented by a block diagram as shown in FIG. 13. The display device 2 may be shown to include a wireless communication unit 920, an input unit 930, a sensor unit 940, an output unit 950, an interface unit 960, a memory 970, and/or a power supply unit 980, as shown in FIG. 13, in addition to the main processor 910.

The wireless communication unit 920 may include at least one of a broadcast receiving module 921, a mobile communication module 922, a wireless Internet module 923, a short-range communication module 924, and a location information module 925.

The broadcast receiving module 921 may receive broadcast signals and/or broadcast-related information from an external broadcast management server through a broadcast channel. The broadcast channel may include satellite channels or terrestrial channels.

The mobile communication module 922 may transmit and receive wireless signals to and from at least one of a base station, an external terminal, and a server on a mobile communication network established according to technical standards or communication schemes for mobile communication (e.g., Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), and Long Term Evolution-Advanced (LTE-A)). The wireless signals may include various forms of data according to voice call signals, video call signals, or text/multimedia message transmission and reception.

The wireless Internet module 923 refers to a module for accessing the wireless Internet. The wireless Internet module 923 may be configured to transmit and receive wireless signals on a communication network according to wireless Internet technologies. The wireless Internet technologies may be, for example, Wireless LAN (WLAN), Wireless-Fidelity (Wi-Fi), Wi-Fi Direct, and/or Digital Living Network Alliance (DLNA).

The short-range communication module 924 is for short range communication and may support short-range communication by using at least one of Bluetooth^{®}, Radio Frequency Identification (RFID), Infrared Data Association (IrDA), Ultra-Wideband (UWB), ZigBee, Near Field Communication (NFC), Wi-Fi, Wi-Fi Direct, and Wireless Universal Serial Bus (Wireless USB). The short-range communication module 924 may support, through a short-range wireless communication network (Wireless Area Networks), wireless communication between the display device 2 and a wireless communication system, between the display device 2 and another electronic device, or between the display device 2 and a network where the other electronic device (or external server) is positioned. The short-range wireless communication network may be a short-range wireless personal communication network (Wireless Personal Area Networks). The other electronic device may be a wearable device capable of mutually exchanging (or linking) data with the display device 2.

The location information module 925 is a module for obtaining a location of the display device 2 and may include a Global Positioning System (GPS) module or a Wi-Fi module.

The input unit 930 may include an image input unit for receiving image signals, such as the camera device 931, an audio input unit for receiving audio signals, such as a microphone 932, and an input device 933 for receiving information from a user. The camera device 931 may process image frames, such as still images and moving images, obtained by an image sensor in a video call mode or a photographing mode. The processed image frame may be displayed on the display panel 10 or stored in the memory 970. The microphone 932 may process external audio signals into electrical speech data. The processed speech data may be variously used depending on the function being performed (or application running) in the display device 2.

The main processor 910 may control operations of the display device 2 to correspond to information received through the input device 933. The input device 933 may include a mechanical input means or a touch input means, such as a button, a dome switch, a jog wheel, and a jog switch, positioned on the rear surface or the side surface of the display device 2. The touch input means may include a touch screen layer of the display panel 10.

The sensor unit 940 may include one or more sensors that sense at least one of information within the display device 2, information about a surrounding environment of the display device 2, and user information, and generate a sensing signal corresponding thereto. Based on the sensing signal described above, the main processor 910 may control driving or operation of the display device 2 or perform data processing, functions, or operations related to applications installed on the display device 2. The sensor unit 940 may be a proximity sensor, an illumination sensor, or a face recognition sensor described above with reference to the component 40. However, the sensor unit 940 may include an acceleration sensor, a magnetic sensor, a G-sensor, a gyroscope sensor, a motion sensor, an RGB sensor, an infrared (IR) sensor, a finger scan sensor, an ultrasonic sensor, an optical sensor, and/or a battery gauge. In addition, the sensor unit 940 may include an environmental sensor or a chemical sensor. For example, the environmental sensor may be a barometer, a hygrometer, a thermometer, a radiation detection sensor, a heat detection sensor, and/or a gas detection sensor. The chemical sensor may be, for example, an electronic nose, a healthcare sensor, and/or a biometric recognition sensor.

The output unit 950 aims to generate an output related to vision, hearing, or tactile sensations, and may include at least one of the display panel 10, an audio output unit 951, a haptic module 952, and an optical output unit 953.

The display panel 10 may display (output) information processed in the display device 2. For example, the display panel 10 may display execution screen information of an application running in the display device 2, display a user interface (UI) according to the execution screen information, or display graphic user interface (GUI) information. The display panel 10 may include a display layer for displaying images and a touch screen layer for detecting a touch input of a user. Due to the above, the display panel 10 may function as one of the input devices 933 that provide an input interface between the display device 2 and the user, and at the same time, may function as one of the output units 950 that provide an output interface between the display panel 10 and the user.

The audio output unit 951 may output audio data received from the wireless communication unit 920 or stored in the memory 970, in a call signal reception mode, a call mode, a recording mode, a speech recognition mode, and/or a broadcast reception mode. The audio output unit 951 may output audio signals related to functions (e.g., call signal reception sound and message reception sound) performed in the display device 2. The audio output unit 951 may include a receiver and a speaker. At least one of the receiver and the speaker may be an audio generation device that is attached to a lower portion of the display panel 10 to vibrate the display panel 10 and output sound. The audio generation device may be a piezoelectric element or a piezoelectric actuator that contract and expand in response to an electric signal, or may be an exciter that generates magnetic force by using a voice coil and vibrates the display panel 10.

The haptic module 952 may generate various tactile effects that may be felt by the user. The haptic module 952 may provide vibration to the user as a tactile effect. The haptic module 952 may not only deliver a tactile effect through direct contact, but may also be implemented so that the user may feel the tactile effect through muscle senses of fingers or arms.

The optical output unit 953 may output a signal for notifying the occurrence of an event by using light from a light source. Examples of the events occurring in the display device 2 may include receiving a message, receiving a call signal, receiving a missed call, an alarm, a schedule reminder, receiving an e-mail, and/or receiving information through an application. A signal output from the optical output unit 953 may be implemented as the display device 2 emits light of one or more colors to the front or the rear. The signal output may be terminated when the display device 2 detects the user's acknowledgement of the event.

The interface unit 960 may serve as a passage to various types of external devices connected to the display device 2. The interface unit 960 may include at least one of a wired/wireless headset port, an external charger port, a wired/wireless data port, a memory card port, a port for connecting a device having an identification module, an audio input/output (I/O) port, a video I/O port, and an earphone port. When an external device is connected to the interface unit 960, the display device 2 may perform an appropriate control related to the connected external device.

The memory 970 may store data supporting various functions of the display device 2. The memory 970 may store a plurality of application programs running in the display device 2 and data and/or instructions for operating the display device 2. At least some of the plurality of applications may be downloaded from an external server through wireless communication. The memory 970 may store applications for operations of the main processor 910, or may temporarily store input/output data, such as a phone book, messages, still images, and moving images. In addition, the memory 970 may store haptic data for vibration of various patterns provided to the haptic module 952, and audio data about various sounds provided to the audio output unit 951.

The memory 970 may include a storage medium of at least one type among a flash memory type, a hard disk type, a solid state disk (SSD) type, a silicon disk drive (SDD) type, a multimedia card micro type, a card-type memory (e.g., Secure Digital (SD) or eXtreme Digital (XD) memory), random access memory (RAM), static RAM (SRAM), read-only memory (ROM), electrically erasable programmable ROM (EEPROM), programmable ROM (PROM), magnetic memory, a magnetic disk, and an optical disk.

Under the control of the main processor 910, the power supply unit 980 may receive external power and/or internal power and supply power to each of elements included in the display device 2. The power supply unit 980 may include the battery 80. In addition, the power supply unit 980 may have a connection port, and the connection port may be an example of the interface unit 960 to which an external charger is electrically connected, wherein the external charger supplies power for battery charging. Alternatively, the power supply unit 980 may also charge the battery 80 in a wireless manner. The battery 80 may be disposed not to overlap the main circuit board 50 in the third direction (z-axis direction). The battery 80 may overlap the battery hole BH defined in the bracket 60.

The lower cover 90 may constitute the exterior of the display device 2, and may have an opening that exposes a portion of the display panel 10. The lower cover 90 may have a shape in which a surface corresponding to the display panel 10 is opened, and may be fastened to the display panel 10. The lower cover 90 may be positioned on an opposite side of the cover window 70 with the display panel 10 therebetween. The lower cover 90 may be disposed under the main circuit board 50 and the battery 80. The lower cover 90 may be fastened and fixed to the bracket 60. The lower cover 90 may constitute the exterior of a lower surface of the display device 2. The lower cover 90 may include plastic, metal, or both plastic and metal.

A second camera hole CMH2 through which a lower surface of the camera device 931 passes may be defined in the lower cover 90. A position of the camera device 931 and positions of the first camera hole CMH1 and the second camera hole CMH2 corresponding to the camera device 931 may overlap each other, as shown in FIG. 12.

Embodiments may provide an apparatus for manufacturing a display device, the apparatus comprising: an ink discharging unit configured to move in a first direction and comprising a head unit including a plurality of nozzles spaced apart from each other and configured to discharge ink toward a substrate; an inspection unit comprising a film member including a same material as the substrate; a camera unit configured to obtain first image information about the ink discharged on the film member; a moving unit configured to move the ink discharging unit and the camera unit in the first direction; and a control unit configured to select at least two nozzles from among the plurality of nozzles to discharge the ink on the substrate based on the first image information.

The head unit may spray the ink toward the substrate and the inspection unit. The head unit may be provided in plurality. For example, the plurality of head units may linearly disposed in the second direction. A connection unit may connect the plurality of head units to each other. The connection unit may be fixed to the moving unit.

Each of the head units may include a plurality of nozzle units. The plurality of nozzle units may include a first nozzle unit, a second nozzle unit, and a third nozzle unit, which are spaced apart from each other. In this case, the first nozzle unit, the second nozzle unit, and the third nozzle unit may discharge the ink containing different materials from each other.

Each nozzle unit may include a plurality of nozzles in a row. In this case, each of the nozzle units may include a plurality of nozzles. The plurality of nozzles may be arranged in a plurality of rows. For example, the plurality of nozzles may be arranged in four rows. In addition, the plurality of nozzles disposed in the rows may be staggered from the plurality of nozzles disposed in another one of the rows. For example, the plurality of nozzles in the rows may be arranged in a serpentine or zigzag manner with respect to each other.

The ink may be discharged through the plurality of nozzles. In this case, the first nozzle unit may discharge the ink including a first material, the second nozzle unit may discharge the ink including a second material, and the third nozzle unit may discharge the ink including a third material.

The plurality of nozzles may be arranged along one surface of the ink discharging unit, e.g., a lower surface of one of the nozzle units, so as to be directed toward the display substrate and the inspection unit.

The camera unit is disposed to face the inspection unit and may photograph the ink discharged on the inspection unit. The camera unit may obtain image information of the discharged ink.

When ink is dried or viscosity of the ink increases within a nozzle of the ink discharging unit, a problem such as clogging of the nozzle may occur. When the ink remaining in the nozzle contains foreign substances or air bubbles the ink discharging unit may cause a high possibility of ink discharge failure.

The control unit may control the inspection unit, the ink discharging unit, the camera unit, and the moving unit. In some embodiments, the control unit may control a cleaning unit, a stage driving unit, and an inspection stage driving unit.

The camera unit may photograph the first image information and transmit the photographed first image information to the control unit, and the control unit may analyze the first image information and identify error information of a nozzle.

The first image information may be a position and shape of the ink on a plane where the ink is disposed. The control unit may identify whether the nozzle normally operates, through the error information of the nozzle. Through such error information of the nozzle, it may be analyzed whether the position of the ink corresponds to a preset position, whether a volume of the ink corresponds to a preset volume, whether the ink exists, or whether additional ink exists adjacent to the ink disposed within a certain range of a reference point.

The control unit may select at least two nozzles to be used among the plurality of nozzles based on the analysis results of the first image information, for example based on error information of the nozzles determined from the first image information. For examples, nozzles with error information or error information that is above a threshold may not be selected.

Second image information photographed by the camera unit may be transmitted to the control unit. The second image information may include a planar position and shape of the ink disposed on the display substrate. The second image information may be similar to the first image information. From the second image information, the control unit may identify whether the ink is disposed at a preset position.

The control unit may control changing of the discharge timing of each nozzle based on the second image information. The control unit may control changing of the discharge timing of the nozzle through a current applied to the nozzle.

Embodiments may provide a method of manufacturing a display device, the method comprising: disposing a film member on an inspection unit; discharging ink on the film member using at least some of a plurality of nozzles of an ink discharging unit; obtaining first image information by photographing the ink discharged on the film member, wherein the first image information includes a position of the ink discharged on the film member and a shape thereof; and selecting, based on the first image information, at least two nozzles, among the plurality of nozzles, to discharge the ink on a substrate.

The selecting, based on the first image information, at least two nozzles, among the plurality of nozzles, to discharge the ink on a substrate may comprise determining error information of the nozzles determined from the first image information, and using the error information of the nozzles to select the at least two nozzles.

According to the one or more embodiments, the quality of a display device may be improved, and the manufacturing speed of the display device may be increased.

The effects of the disclosure are not limited to the effects mentioned above, and other effects not mentioned will be clearly understood by those skilled in the art from the description of the claims.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An apparatus for manufacturing a display device, the apparatus comprising:
an ink discharging unit configured to move in a first direction and comprising a head unit including a plurality of nozzles spaced apart from each other and configured to discharge ink toward a substrate;
an inspection unit comprising a film member including a same material as the substrate;
a camera unit configured to obtain first image information about the ink discharged on the film member;
a moving unit configured to move the ink discharging unit and the camera unit in the first direction; and
a control unit configured to select at least two nozzles from among the plurality of nozzles to discharge the ink on the substrate based on the first image information.

2. The apparatus of claim 1, further comprising:
a stage spaced apart from the head unit in a vertical direction and configured to move in a second direction crossing the first direction,
wherein the substrate is disposed on the stage and the vertical direction is perpendicular to a plane defined by the first direction and the second direction,
wherein the control unit is configured further to control, based on second image information, the ink discharging unit to individually adjust a discharge timing at which each of the at least two nozzles discharges the ink, and
wherein the camera unit is configured further to photograph the ink discharged on the substrate to obtain the second image information.

3. The apparatus of claim 2,
wherein the control unit is configured further to adjust the discharge timing of the ink discharging unit such that one of the at least two nozzles discharges the ink at a first discharge timing and another one of the at least two nozzles discharges the ink at a second discharge timing different from the first discharge timing.

4. The apparatus of claim 2 or 3,
wherein the control unit is configured further to obtain information of a total amount of the ink discharged on the substrate and a position where the ink is discharged on the substrate based on the second image information;
optionally wherein the control unit is configured further to determine a moving speed of the ink discharging unit in the first direction and a position of the ink discharging unit based on the total amount of the ink discharged on the substrate and the position where the ink is discharged on the substrate.

5. The apparatus of any one of claims 2 to 4,
wherein the control unit is configured further to control a movement of the stage so that the discharge timing of each of the at least two nozzles is adjusted by a moving distance of the stage.

6. The apparatus of any one of claims 1 to 5,
wherein the control unit is configured further to generate, based on the first image information, first printing information including a discharge position at which the ink is to be discharged within the substrate;
optionally further comprising: a stage spaced apart from the head unit and configured to move in a second direction, wherein the substrate is disposed on the stage, wherein the camera unit is arranged to obtain second image information by photographing the ink discharged on the substrate, and wherein the control unit is configured further to calculate an injection error of each of the plurality of nozzles based on the first printing information and the second image information.

7. The apparatus of any one of claims 1 to 6,
wherein each of a surface of the film member and a surface of the substrate is water-repellent.

8. The apparatus of any one of claims 1 to 7,
wherein the inspection unit comprises:
an inspection stage configured to support the film member; and
an inspection stage driving unit on which the inspection stage is mounted and configured to move the inspection stage linearly.

9. A method of manufacturing a display device, the method comprising:
disposing a film member on an inspection unit;
discharging ink on the film member using at least some of a plurality of nozzles of an ink discharging unit;
obtaining first image information by photographing the ink discharged on the film member, wherein the first image information includes a position of the ink discharged on the film member and a shape thereof; and
selecting, based on the first image information, at least two nozzles, among the plurality of nozzles, to discharge the ink on a substrate.

10. The method of claim 9, further comprising:
determining, based on the at least two nozzles, first printing information including a position at which the ink is to be discharged on the substrate.

11. The method of claim 10, further comprising:
discharging, by the ink discharging unit based on the first printing information, the ink on the substrate disposed on a stage;
obtaining, by a camera unit, second image information by photographing the ink discharged on the substrate;
calculating an injection error of the ink discharging unit based on the first printing information and the second image information, wherein the first printing information includes a first coordinate of the position at which the ink is to be discharged on the substrate, wherein the second image information includes a second coordinate of a position of the ink in the second image information, and wherein the injection error corresponds to a difference between the second coordinate and the first coordinate; and
generating second printing information based on the injection error,
wherein the second printing information includes a position of the stage on which the substrate is placed, a position of the ink discharging unit, and a discharge timing when each of the plurality of nozzles discharges an ink at least one of which is different from a corresponding one of a previous second printing information;
optionally further comprising: adjusting an operation of the ink discharging unit differently according to whether the injection error is positive or negative, wherein the injection error is positive when the second coordinate is greater than the first coordinate, and the injection error is negative when the second coordinate is smaller than the first coordinate, further optionally wherein an operation of each of the plurality of nozzles of the ink discharging unit is individually adjusted based on the injection error;
optionally further comprising: changing, based on the injection error, a timing at which the ink is discharged from at least one nozzle from among the plurality of nozzles.

12. The method of claim 10 or 11, further comprising:
determining, based on the first image information, whether each of the plurality of nozzles normally operates.

13. The method of any one of claims 9 to 12,
wherein a surface of the film member and a surface of the substrate are water-repellent.

14. The method of any one of claims 11 to 13, further comprising:
setting a moving distance of a head unit of the ink discharging unit based on the injection error.

15. The method of any one of claims 9 to 14, further comprising:
moving the film member linearly.
